# EUROPEAN PATENT APPLICATION

(11) **EP 4 761 519 A1**
(43) Date of publication of application: **17.06.2026**
(21) Application number: 25170096.9
(22) Date of filing: 11.04.2025
(51) Int. Cl.: H10F 19/80, H10F 19/90

(54) **METHOD FOR MANUFACTURING PHOTOVOLTAIC MODULE**

(30) Priority: 11.12.2024 CN 202411823729
(71) Applicant: JINKO SOLAR CO., LTD, ShangRao, Jiangxi 334100 (CN); Jinko Solar (Haining) Co., Ltd., Haining City, Zhejiang 314415 (CN)
(72) Inventor: TAO, Wusong, JIANGXI, 334100 (CN); WANG, Luchuang, JIANGXI 334100 (CN); BAI, Meiyan, JIANGXI, 334100 (CN); CHEN, Shuping, JIANGXI, 334100 (CN); XU, Tao, JIANGXI, 334100 (CN)
(74) Representative: Herrero & Asociados, S.L.

(57) **Abstract**

The present disclosure relates to the technical field of solar cells, and in particular to a method for manufacturing a photovoltaic module. In present embodiments, a plurality of solder strips, a plurality of adhesive dots, and a covering film are arranged on a target side of a solar cell in a preset sequence during forming a solar cell string, each solder strip corresponds to at least one adhesive dot, and the covering film at least covers the sides of the plurality of solder strips away from the solar cell, so that the plurality of solder strips can be fixed relative to the solar cell through the adhesive dots and the covering film.

## Description

### TECHNICAL FIELD

The present disclosure relates to the technical field of solar cells, and in particular to a method for manufacturing a photovoltaic module.

### BACKGROUND

During manufacturing a photovoltaic module, a plurality of solar cells are required to be connected by means of solder strips to form a solar cell string, and then, relevant processing such as laminating and framing is carried out to form the photovoltaic module. Reliability of the connection between the solder strip and the corresponding solar cell can affect reliability of the photovoltaic module. Therefore, the reliability of the connection between the solder strip and the corresponding solar cell is required to be further improved.

### SUMMARY

Based on this, it is necessary to provide a method for manufacturing a photovoltaic module to improve the reliability of the connection between the solder strip and the solar cell, thereby improving the reliability of the photovoltaic module.

Embodiments of the present disclosure provide a method for manufacturing a photovoltaic module, including:
providing solar cells; and
connecting a plurality of solar cells to form a solar cell string according to a preset string forming mode;
wherein during forming the solar cell string, a plurality of solder strips, a plurality of adhesive dots, and a covering film are arranged on a target side of the solar cell in a preset sequence;
for the same target side, the covering film is located on a side of the solder strip away from the solar cell, and an orthographic projection of the covering film on a reference plane and orthographic projections of the plurality of solder strips on the reference plane have an overlapped projection; each solder strip corresponds to at least one adhesive dot, and an orthographic projection of the adhesive dot on the reference plane and an orthographic projection of the corresponding solder strip on the reference plane have an overlapped projection; and the target side of the solar cell is at least one side of the solar cell along a first direction, the first direction is a thickness direction of the solar cell, and the reference plane is a plane perpendicular to the first direction.

In an embodiment, among all the adhesive dots on the same target side of the same solar cell, a first target adhesive dot exists; and
at least a part of the first target adhesive dot is located between the corresponding solder strip and the corresponding solar cell along the first direction.

In an embodiment, for the same target side of the same solar cell, an orthographic projection of at least one first target adhesive dot on the reference plane and an orthographic projection of the corresponding covering film on the reference plane have an overlapped projection; and/or
for the same target side of the same solar cell, an orthographic projection of at least one first target adhesive dot on the reference plane is not overlapped with an orthographic projection of the corresponding covering film on the reference plane.

In an embodiment, among all the adhesive dots on the same target sides of all the solar cells, a second target adhesive dot exists; and
at least a part of the second target adhesive dot is located between the corresponding solder strip and the corresponding covering film along the first direction.

In an embodiment, among all the adhesive dots on the same target sides of all the solar cells, a third target adhesive dot exists; and at least a part of the third target adhesive dot is located on a side of the corresponding covering film away from the solar cell along the first direction; and/or
among all the adhesive dots on the same target sides of all the solar cells, a fourth target adhesive dot exists; and at least a part of the fourth target adhesive dot is located on a side of the corresponding solder strip away from the solar cell along the first direction.

In an embodiment, for the same target sides of all the solar cells, one covering film is provided, and an orthographic projection of at least a part of the solder strip on the reference plane and an orthographic projection of the corresponding covering film on the reference plane have an overlapped projection; or
for the same target sides of all the solar cells, a plurality of covering films are provided, each covering film covers at least one solar cell, the covering films are all not overlapped with each other, and an orthographic projection of at least a part of the solder strip on the reference plane and an orthographic projection of the corresponding covering film on the reference plane have an overlapped projection; or
for the same target sides of all the solar cells, a plurality of covering films are provided, all the covering films and all the solar cells are arranged in one-to-one correspondence, and an orthographic projection of at least a part of the solder strip on the reference plane and an orthographic projection of the corresponding covering film on the reference plane have an overlapped projection.

In an embodiment, each solder strip corresponds to a plurality of adhesive dots;
orthographic projections of the plurality of adhesive dots on the reference plane respectively have an overlapped projection with an orthographic projection of the corresponding solder strip on the reference plane.

In an embodiment, the solder strip has a first end portion and a second end portion oppositely arranged along a lengthwise direction of the solder strip;
for the plurality of adhesive dots, an orthographic projection of one of the plurality of adhesive dots on the reference plane and an orthographic projection of the first end portion of the corresponding solder strip on the reference plane have an overlapped projection; and an orthographic projection of another adhesive dot on the reference plane and an orthographic projection of the second end portion of the corresponding solder strip on the reference plane have an overlapped projection.

In an embodiment, the covering film is configured into a single-layer structure, and a pre-cross-linking degree of the covering film is 20% to 50%; or
the covering film is configured into a multi-layer structure, the covering film includes a plurality of stacked sub-covering films, and a pre-cross-linking degree of a sub-covering film in the plurality of sub-covering films closest to the solar cell is 20% to 50%.

In an embodiment, for the same target side of the same solar cell, an orthographic projection of each solder strip on the reference plane and an orthographic projection of the corresponding covering film on the reference plane have an overlapped projection; and/or
a lowest torque value ML of the covering film satisfies: 0.1≤ML≤0.8; and/or
a temperature of the covering film during application is 100°C to 135°C; and/or
a thickness of the covering film is 50 µm to 500 µm; and/or
the method further includes curing the adhesive dots during forming the solar cell string, and a cross-linking degree of the adhesive dots after curing is larger than 90%; and/or

Tg of the adhesive dot is larger than or equal to 59.40°C; where Tg is a temperature at which the adhesive dot is transformed from a glassy state to a high-condensed state; and/or
the solder strip includes at least one of a round wire solder strip, a triangular solder strip, a flat solder strip, or a special-shaped solder strip.

According to the above method for manufacturing the photovoltaic module, in the process of forming the solar cell string, the plurality of solder strips, the plurality of adhesive dots, and the covering film are arranged on the target side of the solar cell in the preset sequence, each solder strip corresponds to at least one adhesive dot, and the covering film at least covers the sides of the plurality of solder strips away from the solar cell, so that the plurality of solder strips can be fixed relative to the solar cell through the adhesive dots and the covering film, thus improving the reliability of the welding connection between the solder strips and the solar cell, and further improving the reliability of the photovoltaic module.

Additional aspects and advantages of embodiments of the present disclosure will be set forth in part in the description which follows and, in part, will be obvious from the description, or can be learned by practice of the embodiments of the present disclosure.

### BRIEF DESCRIPTION OF THE DRAWINGS

Through reading detailed descriptions of the following embodiments, those of ordinary skill in the art may understand various advantages and benefits. The accompanying drawings are merely intended to illustrate objectives of the embodiments, but are not interpreted as limitations on the present disclosure. In addition, the same reference sign is used to indicate the same member throughout the accompanying drawings. In the drawings:
FIG. 1 is a schematic flowchart of a method for manufacturing a photovoltaic module according to some embodiments of the present disclosure.
FIG. 2 is a schematic side sectional structural view of a part of a structure where a solder strip, an adhesive dot, a covering film, and a solar cell cooperate provided in some embodiments of the present disclosure.
FIG. 3 is a schematic top structural view of a part of a structure where the solder strip, the adhesive dot, and the solar cell cooperate provided in some embodiments of the present disclosure.
FIG. 4 is a schematic top structural view of a part of the structure where the solder strip, the adhesive dot, the covering film, and the solar cell cooperate provided in some embodiments of the present disclosure.
FIG. 5 is a schematic top structural view of a part of the structure where the solder strip, the adhesive dot, the covering film, and the solar cell cooperate provided in further embodiments of the present disclosure.
FIG. 6 is a schematic top structural view of a part of the structure where the solder strip, the adhesive dot, the covering film, and the solar cell cooperate provided in still further embodiments of the present disclosure.
FIG. 7 is a schematic side sectional structural view of a part of the structure where the solder strip, the adhesive dot, the covering film, and the solar cell cooperate provided in further embodiments of the present disclosure.
FIG. 8 is a schematic side sectional structural view of a part of the structure where the solder strip, the adhesive dot, the covering film, and the solar cell cooperate provided in still further embodiments of the present disclosure.
FIG. 9 is a schematic top structural view of a part of the structure where the solder strip, the adhesive dot, the covering film, and the solar cell cooperate provided in yet further embodiments of the present disclosure.
FIG. 10 is a schematic side sectional structural view of a part of the structure where the solder strip, the adhesive dot, the covering film, and the solar cell cooperate provided in yet further embodiments of the present disclosure.
FIG. 11 is a schematic top structural view of a part of the structure where the solder strip, the adhesive dot, the covering film, and the solar cell cooperate provided in further embodiments of the present disclosure.
FIG. 12 is a schematic side sectional structural view of a part of the structure where the solder strip, the adhesive dot, the covering film, and the solar cell cooperate provided in further embodiments of the present disclosure.
FIG. 13 is a schematic top structural view of a part of the structure where the solder strip, the adhesive dot, the covering film, and the solar cell cooperate provided in further embodiments of the present disclosure.
FIG. 14 is a schematic top structural view of a part of the structure where the solder strip, the adhesive dot, the covering film, and the solar cell cooperate provided in further embodiments of the present disclosure.
FIG. 15 is a schematic top structural view of cooperation of the covering film and a plurality of solar cells in some embodiments of the present disclosure.
FIG. 16 is a schematic top structural view of the cooperation of the covering film and the plurality of solar cells in further embodiments of the present disclosure.
FIG. 17 is a schematic top structural view of the cooperation of the covering film and the plurality of solar cells in still further embodiments of the present disclosure.
FIG. 18 is a schematic top structural view of a part of the structure where the solder strip, the adhesive dot, and the solar cell cooperate provided in further embodiments of the present disclosure.
FIG. 19 is a schematic side sectional structural view of a part of the structure where the solder strip, the adhesive dot, and the solar cell cooperate provided in some embodiments of the present disclosure.
FIG. 20 is a schematic top structural view of a part of a structure where the solder strip and the adhesive dot cooperate provided in some embodiments of the present disclosure.
FIG. 21 is a schematic side sectional structural view of a part of the structure where the solder strip, the adhesive dot, and the solar cell cooperate provided in further embodiments of the present disclosure.
FIG. 22 is a schematic top structural view of a part of the structure where the solder strip and the adhesive dot cooperate provided in further embodiments of the present disclosure.
FIG. 23 is a schematic structural view of the photovoltaic module in some embodiments of the present disclosure.
FIG. 24 is a schematic structural view of cooperation of the solder strip and the solar cell in some embodiments of the present disclosure.
FIG. 25 is a schematic structural view of a solar cell string in some embodiments of the present disclosure.
FIG. 26 is a schematic structural view of the solar cell string in further embodiments of the present disclosure.
FIG. 27 is a schematic structural view of the solar cell string in still further embodiments of the present disclosure.
FIG. 28 is a schematic structural view of the solar cell string in yet further embodiments of the present disclosure.
FIG. 29 is a schematic structural view of the cooperation of the solder strip and the solar cell in further embodiments of the present disclosure.
FIG. 30 is a schematic structural view of the solar cell string in further embodiments of the present disclosure.
FIG. 31 is a schematic structural view of the solar cell string in yet further embodiments of the present disclosure.

Reference signs:
photovoltaic module 10; solar cell string 100; solar cell 110; solder strip 120; first end portion e1; second end portion e2; adhesive dot 130; first sub-adhesive dot 131; second sub-adhesive dot 132; first target adhesive dot 130a; second target adhesive dot 130b; third target adhesive dot 130c; fourth target adhesive dot 130d; covering film 140; encapsulation layer 200; cover plate 300; steps S110 and S120.

### DETAILED DESCRIPTION

In order to make the afore-mentioned objectives, features and advantages of the present disclosure more apparent, embodiments of the present disclosure are described below in detail with reference to the accompanying drawings. In the following description, numerous specific details are set forth to provide a thorough understanding of the present disclosure. However, the present disclosure can be implemented in many ways different from those described herein, those skilled in the art may make similar improvements without departing from the essence of the present disclosure, and therefore, the present disclosure is not limited to the examples disclosed below.

In the description of the present disclosure, it should be understood that the orientation or position relationship indicated by the terms "central", "longitudinal", "transverse", "length", "width", "thickness", "upper", "lower", "front", "back", "left", "right", "vertical", "horizontal", "top", "bottom", "inner", "outer", "clockwise", "counterclockwise", "axial", "radial", "circumferential", etc. are based on the orientation or position relationship shown in the accompanying drawings and are only intended to facilitate the description of the present disclosure and simplify the description, rather than indicating or implying that the device or element referred to must have a particular orientation or be constructed and operated in a particular orientation, and therefore are not to be interpreted as limitations on the present disclosure.

In addition, terms "first" and "second" are used herein for purposes of description and shall not be construed as indicating or implying a relative importance, or implicitly specifying the number of the indicated technical features. Thus, the feature defined with "first" and "second" may include at least one of the feature explicitly or implicitly. In the description of the present disclosure, "a plurality of" means at least two, such as two, three, or the like, unless otherwise specifically defined.

In the present disclosure, unless specifically stated and limited, the terms "mounting," "coupling", "connecting", "fixing", etc. should be understood in a broad sense. It may be, for example, a fixed connection, a detachable connection, or an integral connection; a mechanical connection or an electrical connection; a direct connection, an indirect connection through an intermediate medium, an internal connection of two elements, or an interaction of two elements, unless otherwise specified. It should be noted that in the following description, the term "electrically connected" between one feature and another feature not only includes the one feature being in direct contact with the other feature to form a power transmission or current transfer channel, but also indicates an intermediate feature between the one feature and the other feature, the one feature, the other feature, and the intermediate feature therebetween forming a power transmission or current transfer channel to realize power transmission or transfer. For those of ordinary skilled in the art, the specific meanings of the above terms in the present disclosure can be understood according to specific circumstances.

In the present disclosure, unless specified or limited otherwise, the description that a first feature is "on" or "below" a second feature may mean that the first feature is in direct contact with the second feature, or the first feature and the second feature are contacted via an additional feature formed therebetween. Furthermore, a first feature "on," "above," or "on top of" a second feature may include an embodiment in which the first feature is right or obliquely "on", "above", or "on top of" the second feature, or just means that the first feature is at a height higher than that of the second feature; while a first feature "below", "under", or "on bottom of" a second feature may include an embodiment in which the first feature is right or obliquely "below", "under", or "on bottom of" the second feature, or just means that the first feature is at a height lower than that of the second feature.

It should be noted that when an element is referred to as being "fixed on" or "provided at" another element, the element can be directly located on the other element or an intermediate element may exist. If one element is considered to be "connected" to another element, it can be directly connected to the another element or an intermediate element may co-exist. As used herein, the terms "vertical", "horizontal", "upper", "lower", "left", "right", or the like, are for purposes of illustration only and do not denote a sole embodiment.

When a photovoltaic module is used, local power generation efficiencies can be different due to different illuminances of surfaces of solar cells, resulting in an excessively high local temperature. In this case, a stress is generated at a connection interface between a solder strip and the solar cell due to different thermal expansion coefficients between the solder strip and the solar cell, and long-term stress will cause the bonding between a solder at a soldering point and the solar cell or the solder strip to gradually loosen. A good intermetallic compound connection originally formed with the solder can be damaged, so that the electric contact between the solder strip and the solar cell becomes unstable, an insufficient soldering phenomenon is generated, current transportation between the solar cells is blocked, the power generation efficiency of the photovoltaic module is reduced, and even potential safety risks such as local overheating can be caused, thereby reducing reliability of the photovoltaic module.

Based on these, embodiments of the present disclosure improve the method for manufacturing the photovoltaic module to improve the reliability of the connection between the solder strip and the solar cell, thereby improving the reliability of the photovoltaic module.

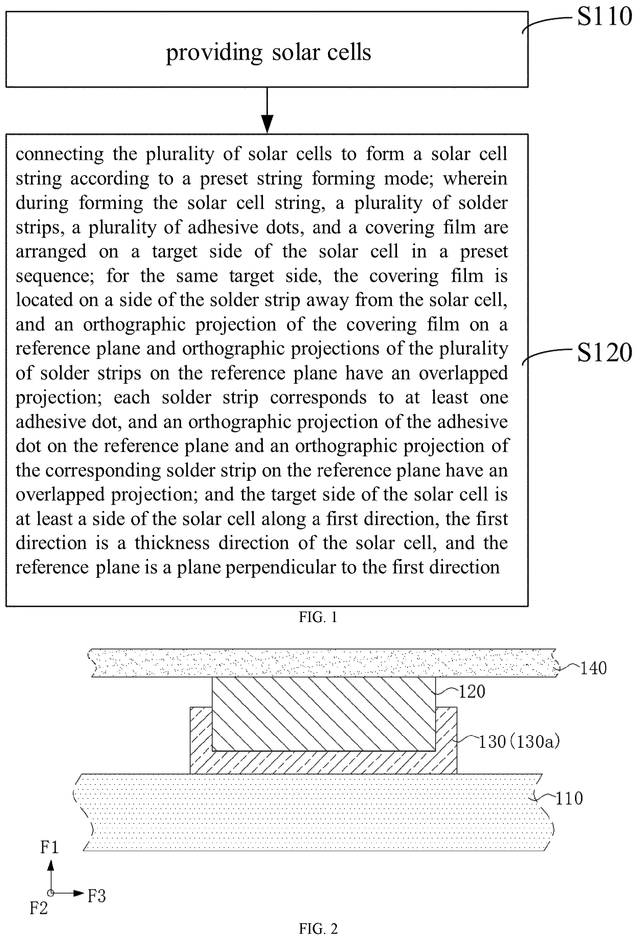

FIG. 1 shows a schematic flowchart of a method for manufacturing a photovoltaic module according to some embodiments of the present disclosure. For convenience of explanation, only contents related to the embodiments of the present disclosure are shown.

Referring to FIG. 1, embodiments of the present disclosure provide a method for manufacturing a photovoltaic module, including:
step S110: providing solar cells; and
step S120: connecting a plurality of solar cells to form a solar cell string according to a preset string forming mode; wherein in the process of forming the solar cell string, a plurality of solder strips, a plurality of adhesive dots, and a covering film are arranged on a target side of the solar cell in a preset sequence; for the same target side, the covering film is located on a side of the solder strip away from the solar cell, and an orthographic projection of the covering film on a reference plane and orthographic projections of the plurality of solder strips on the reference plane have an overlapped projection; each of the solder strips corresponds to at least one adhesive dot, and an orthographic projection of the adhesive dot on the reference plane and an orthographic projection of the corresponding solder strip on the reference plane have an overlapped projection; and the target side of the solar cell is at least one side of the solar cell along a first direction, the first direction is a thickness direction of the solar cell, and the reference plane is a plane perpendicular to the first direction.

In the step S110, the solar cells can be configured according to actual use requirements. In some embodiments, the solar cell can be a Tunnel Oxide Passivating Contacts (TOPCon) cell, a Back Contact (BC) cell, an Heterojunction with Intrinsic Thin-layer (HJT) cell, a perovskite cell, a tandem cell, or the like. The tandem cell can be formed by stacking a perovskite cell with a TOPCon cell, a BC cell, or an HJT cell, which is not limited herein. The solar cell can be a monolithic solar cell, a half-cut solar cell, or a small solar cell slice, which is not limited herein.

In the step S120, the preset string forming mode refers to a connection mode pre-designed for the plurality of solar cells, and the plurality of solar cells can be combined, so that a current and a voltage generated by the plurality of solar cells can meet a power requirement and an electrical characteristic requirement of the photovoltaic module. The preset string forming mode includes, but is not limited to, an electrical connection mode of solar cells, an arrangement mode of solar cells, a placement mode of solder strips, and an arrangement mode of solder strips. For the connection mode of the solar cells in the solar cell string, a front electrode of one solar cell is electrically connected to a back electrode of an adjacent solar cell through the solder strip (for example, for the TOPCon cell), or a back electrode of one solar cell is electrically connected to a back electrode of an adjacent solar cell through the solder strip (for example, for the BC cell). The plurality of solar cells can be connected in series, in parallel, or in series and in parallel, which is not limited herein.

The target side of the solar cell can be a front side of the solar cell, or a back side of the solar cell. For example, in the case where the solar cell is a TOPCon cell, the target side of the solar cell can be at least one of the front side and the back side of the solar cell. For another example, in the case where the solar cell is a BC cell, the target side of the solar cell can be the back side of the solar cell. The target side can be configured according to types and applications of the solar cells.

It can be understood that a front surface of the solar cell is a light receiving surface, and a back surface of the solar cell is a backlight surface. The light receiving surface and the backlight surface are relative, and the light receiving surface is a surface of the solar cell in the photovoltaic module on which sunlight mainly irradiates. With the development of the solar cell technology, the backlight surface can also receive energy of sunlight, mainly from reflected light or scattered light in a surrounding environment.

The solder strip is a strip for electronic elements. The solder strip is mainly configured to connect the solar cells to form a good electrical connection between the solar cells, so that the current generated by respective solar cell is collected and conducted out. The solder strip is generally a strip-like component, and generally has certain flexibility, thereby facilitating a soldering operation between the solar cells. A material of the solder strip includes, but is not limited to, a tin-lead alloy, a lead-free alloy (such as a tin-silver-copper alloy), etc. The covering film is a film covering the surface of the solar cell. A material of the covering film includes, but is not limited to, one or more of Ethylene-Vinyl Acetate (EVA), Polyolefin Elastomer (POE), Thermoplastic Polyolefin (TPO), and Thermoplastic Polyurethane (TPU). The adhesive dot is a component formed with a material having a certain adhesive capability. The material of the adhesive dot includes at least one of acrylic resin, epoxy resin, and conductive glue.

The plurality of solder strips, the plurality of adhesive dots, and the covering film are arranged on the target side of the solar cell in the preset sequence. That is, the solder strips, the adhesive dots, and the covering film are arranged in sequence; alternatively, the adhesive dots, the solder strips, and the covering film are arranged in sequence; alternatively, the solder strips, the covering film, and the adhesive dots are arranged in sequence. Certainly, it is also possible that the solder strips and the adhesive dots are alternately arranged, and then, the covering film is arranged. The sequence of arranging the plurality of solder strips, the plurality of adhesive dots, and the covering film can be configured according to specific arrangement conditions, which is not limited herein.

The orthographic projection of the covering film on the reference plane and the orthographic projections of the plurality of solder strips on the reference plane have an overlapped projection, that is, the orthographic projection of the covering film on the reference plane and the orthographic projections of the plurality of solder strips on the reference plane can be completely overlapped or can be not completely overlapped. It is only required that the covering film corresponds to at least a part of the solder strips in the thickness direction of the solar cell, which is not specifically limited herein.

Each solder strip corresponds to at least one adhesive pot, that is, each solder strip corresponds to at least one adhesive pot in the thickness direction of the solar cell. The orthographic projection of the adhesive dot on the reference plane and the orthographic projection of the corresponding solder strip on the reference plane have an overlapped projection, that is, the orthographic projection of the adhesive dot on the reference plane can be completely located in a range of the orthographic projection of the corresponding solder strip on the reference plane; alternatively, the orthographic projection of the adhesive dot on the reference plane can be partially located in a range of the orthographic projection of the corresponding solder strip on the reference plane. According to different preset sequences and different arrangement positions, the solder strip can be in contact with the corresponding adhesive dot; alternatively, the solder strip can be not in contact with the corresponding adhesive dot.

The orthographic projection of the covering film on the reference plane and the orthographic projections of the plurality of adhesive dots on the reference plane can or cannot have an overlapped projection, which is not limited herein. In the case where the orthographic projection of the covering film on the reference plane and the orthographic projections of the plurality of adhesive dots on the reference plane do not have an overlapped projection, the orthographic projection of the covering film on the reference plane and the orthographic projections of the plurality of solder strips on the reference plane are partially overlapped.

Thus, in the thickness direction of the solar cell, the solder strip and the corresponding adhesive dot have the overlapped projection, and the covering film and the plurality of solder strips have the overlapped projection, so that the plurality of solder strips can be fixed relative to the solar cell through the adhesive dots and the covering film, thus improving stability between the solder strips and the solar cell. Even if the photovoltaic module has an excessively high local temperature during use, under the restriction effect of the adhesive dot and the covering film, the solder strip still can keep good ohmic contact with the solar cell, thereby improving the reliability of the welding connection between the solder strip and the solar cell, thereby improving the reliability of the photovoltaic module.

In some embodiments, among all the adhesive dots on the same target side of the same solar cell, a first target adhesive dot exists. At least a part of the first target adhesive dot is located between the corresponding solder strip and the solar cell along the first direction.

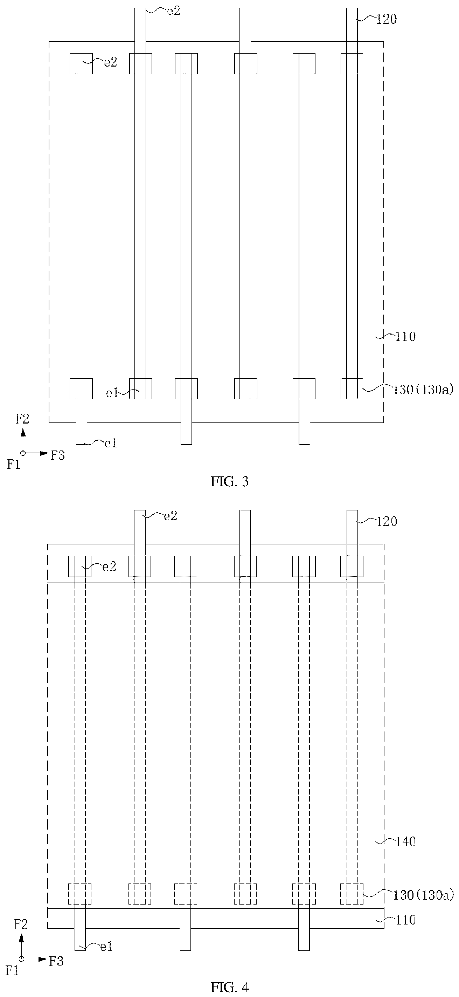

For example, with respective to the solder strip, the first target adhesive dot is first arranged on the solar cell. Referring to FIG. 2, FIG. 2 shows a schematic side sectional structural view of a part of a structure where the solder strip 120, the adhesive dot 130, the covering film 140, and the solar cell 110 cooperate provided in some embodiments of the present disclosure. As illustrated in FIG. 2, only one solder strip 120 is shown, and the first target adhesive dot 130a can be partially located between the solder strip 120 and the solar cell 110 and partially located at a side edge of the solder strip 120. Certainly, the first target adhesive dot 130a may alternatively be located between the solder strip 120 and the solar cell 110, which is not limited herein. Referring to FIG. 3, FIG. 3 shows a schematic top structural view of a part of a structure where the solder strips 120, the adhesive dots 130, and the solar cell 110 cooperate provided in some embodiments of the present disclosure. The covering film 140 is omitted in FIG. 3, and it is possible that all the adhesive dots 130 on the same target side of the same solar cell 110 are the first target adhesive dots 130a. Certainly, it is also possible that one adhesive dot 130 of all adhesive dots 130 on the same target side of the same solar cell 110 is the first target adhesive dot 130a; alternatively, some adhesive dots 130 of all adhesive dots 130 on the same target side of the same solar cell 110 are the first target adhesive dots 130a. In the case where among all adhesive dots 130 on the same target side of the same solar cell 110, adhesive dots other than the first target adhesive dot 130a exist, these adhesive dots can be arranged with reference to some configurations of adhesive dots 130 illustrated later, which is not limited herein.

Thus, by providing the first target adhesive dot, the corresponding solder strip can be positioned more accurately, and the corresponding solder strip and the corresponding solar cell can be fixed together preliminarily, thus facilitating an increase of a tension between the corresponding solder strip and the corresponding solar cell, and improving structural stability between the corresponding solder strip and the corresponding solar cell.

In some embodiments, for the same target side of the same solar cell, an orthographic projection of at least one first target adhesive dot on the reference plane and an orthographic projection of the corresponding covering film on the reference plane have an overlapped projection; and/or for the same target side of the same solar cell, the orthographic projection of at least one first target adhesive dot on the reference plane and the orthographic projection of the corresponding covering film on the reference plane are not overlapped. The overlapped projection can be understood by referring to the situation illustrated in some embodiments described above, which is not repeated herein.

In some embodiments, referring to FIG. 4, FIG. 4 shows a schematic top structural view of a part of the structure where the solder strip 120, the adhesive dot 130, the covering film 140, and the solar cell 110 cooperate provided in some embodiments of the present disclosure. The structure covered by the covering film 140 in the first direction is illustrated in a dashed line in FIG. 4. As viewed from the first direction, a part of the first target adhesive dots 130a are covered by the covering film 140, that is, orthographic projections of the part of the first target adhesive dots 130a on the reference plane are located within a range of an orthographic projection of the covering film 140 on the reference plane, and the overlapped projection of both projections is the orthographic projection of the part of the first target adhesive dots 130a on the reference plane. With continued reference to FIG. 4, as viewed from the first direction, another part of the first target adhesive dots 130a is not covered by the covering film 140, that is, an orthographic projection of the another part of the first target adhesive dots 130a on the reference plane is located outside the range of the orthographic projection of the covering film 140 on the reference plane.

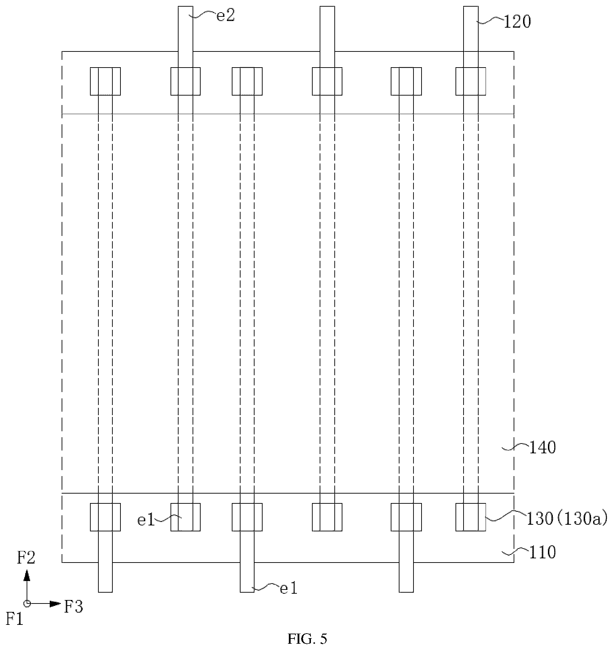

In some embodiments, referring to FIG. 5, FIG. 5 shows a schematic top structural view of a part of the structure where the solder strip 120, the adhesive dot 130, the covering film 140, and the solar cell 110 cooperate provided in further embodiments of the present disclosure. A structure covered by the covering film 140 in the first direction is illustrated in a dashed line in FIG. 5. As viewed from the first direction, all the first target adhesive dots 130a are not covered by the covering film 140. That is, the orthographic projections of all the first target adhesive dots 130a on the reference plane are located outside the range of the orthographic projection of the covering film 140 on the reference plane.

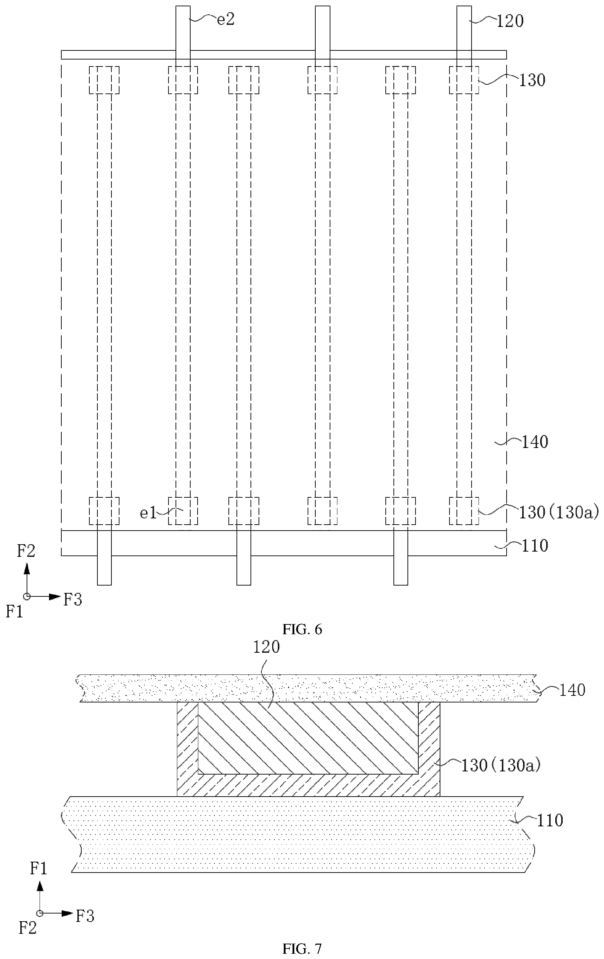

In some embodiments, referring to FIG. 6, FIG. 6 shows a schematic top structural view of a part of the structure where the solder strip 120, the adhesive dot 130, the covering film 140, and the solar cell 110 cooperate provided in still further embodiments of the present disclosure. A structure covered by the covering film 140 in the first direction is illustrated in a dashed line in FIG. 6. As viewed from the first direction, all the first target adhesive dots 130a are covered by the covering film 140. That is, the orthographic projections of all the first target adhesive dots 130a on the reference plane are located within the range of the orthographic projection of the covering film 140 on the reference plane.

Thus, in the case where the first target adhesive dot is located on a side of the covering film facing the solar cell, and the first target adhesive dot and the covering film have the overlapped projection, the first target adhesive dot, the corresponding covering film, and the corresponding solder strip have corresponding parts in the first direction, so that a support point for the covering film is favorably provided, the stability of the electrical connection between the solder strip and the solar cell under the action of the adhesive dot and the covering film is further improved, and the stress generated due to different thermal expansion coefficients of the solar cell, the solder strip, and the covering film is favorably absorbed and dispersed during the temperature change, thereby reducing the problems of cracking of the solar cell and loosening of the solder strip, and improving the mechanical stability of the photovoltaic module.

Further, referring to FIG. 7, FIG. 7 shows a schematic side sectional structural view of a part of the structure where the solder strip 120, the adhesive dot 130, the covering film 140, and the solar cell 110 cooperate provided in further embodiments of the present disclosure. By controlling a thickness of the first target adhesive dot 130a along the first direction, the covering film 140 is in contact with a side of the solder strip 120 away from the solar cell 110 and is in contact with a side of the first target adhesive dot 130a away from the solar cell 110. In this case, the first target adhesive dot 130a can not only improve the stability of the connection between the solder strip 120 and the solar cell 110, but also further improve the bonding force of the covering film 140 on the solder strip 120.

Therefore, by providing the first target adhesive dot, and flexibly configuring a relationship between the first target adhesive dot and the solder strip and the covering film, the reliability of the electrical connection between the solder strip and the solar cell can be further improved, thereby improving the reliability of the photovoltaic module.

In some embodiments, among all the adhesive dots on the same target sides of all the solar cells, a second target adhesive dot exists. At least a part of the second target adhesive dot is located between the corresponding solder strip and the corresponding covering film along the first direction. For example, the second target adhesive dot is arranged on the solar cell after the solder strip.

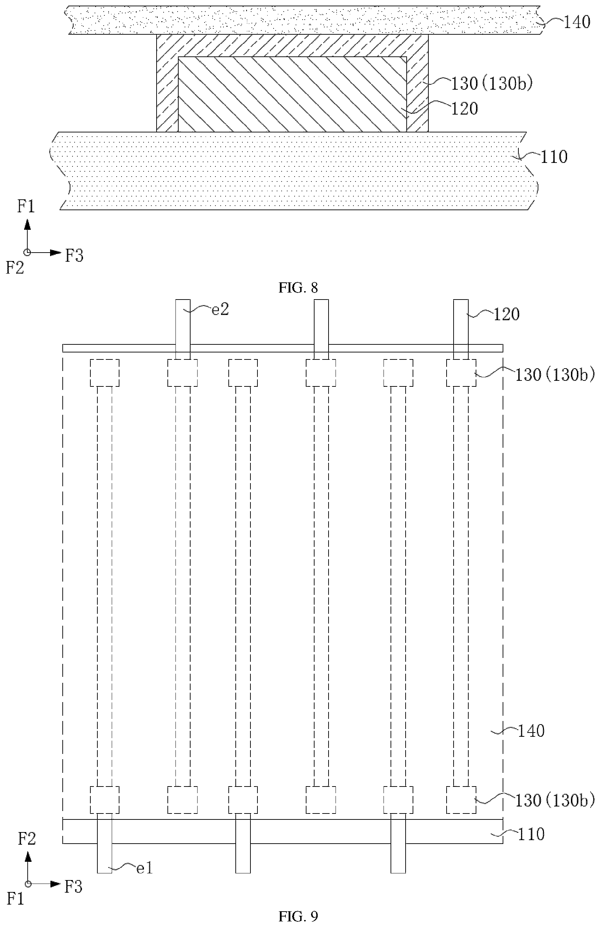

In some embodiments, referring to FIG. 8, FIG. 8 shows a schematic side sectional structural view of a part of the structure where the solder strip 120, the adhesive dot 130, the covering film 140, and the solar cell 110 cooperate provided in still further embodiments of the present disclosure. A part of the second target adhesive dot 130b is in contact with the corresponding solder strip 120, and another part of the second target adhesive dot is in contact with the corresponding covering film 140. Further, a further part of the second target adhesive dot 130b can be in contact with the side of the solder strip 120.

In some embodiments, referring to FIG. 9, FIG. 9 is a schematic top structural view of a part of the structure where the solder strip 120, the adhesive dot 130, the covering film 140, and the solar cell 110 cooperate provided in yet further embodiments of the present disclosure. The situation where the second target adhesive dots 130b are all located between the corresponding solder strips 120 and the corresponding covering film 140 along the first direction is illustrated. Certainly, it is also possible that a part of the second target adhesive dots 130b are located between the corresponding solder strips 120 and the corresponding covering film 140 along the first direction. In FIG. 9, a structure covered with the covering film 140 in the first direction is illustrated in a dashed line.

Thus, by providing the second target adhesive dot, the bonding force of the covering film on the solder strip can be further increased, thereby improving the reliability of the electrical connection between the solder strip and the solar cell. In addition, during fabrication, transportation and use of the photovoltaic module, the photovoltaic module may experience various mechanical stresses (e.g., pressure during lamination, material expansion and contraction caused by temperature changes, or the like). The second target adhesive dots located between the corresponding solder strips and the corresponding covering film can be used as buffer components to absorb and disperse the stresses, so that peeling or damage between the solder strips and the covering film due to stress concentration can be decreased, while reducing an influence of the stress on the solar cell, and reducing the risk of cracking of the solar cell.

In some embodiments, among all the adhesive dots on the same target sides of all the solar cells, a third target adhesive dot exists. At least a part of the third target adhesive dot is located on a side of the corresponding covering film away from the solar cell along the first direction. And/or a fourth target adhesive dot exists among all the adhesive dots on the same target sides of all the solar cells; and at least a part of the fourth target adhesive dot is located on a side of the corresponding solder strip away from the solar cell along the first direction. For example, the third target adhesive dot is arranged on the solar cell after the covering film. The fourth target adhesive dot is arranged on the solar cell after the solder strip. The fourth target adhesive dot can be arranged before the covering film; alternatively, the fourth target adhesive dot can be arranged after the covering film, which is not limited herein.

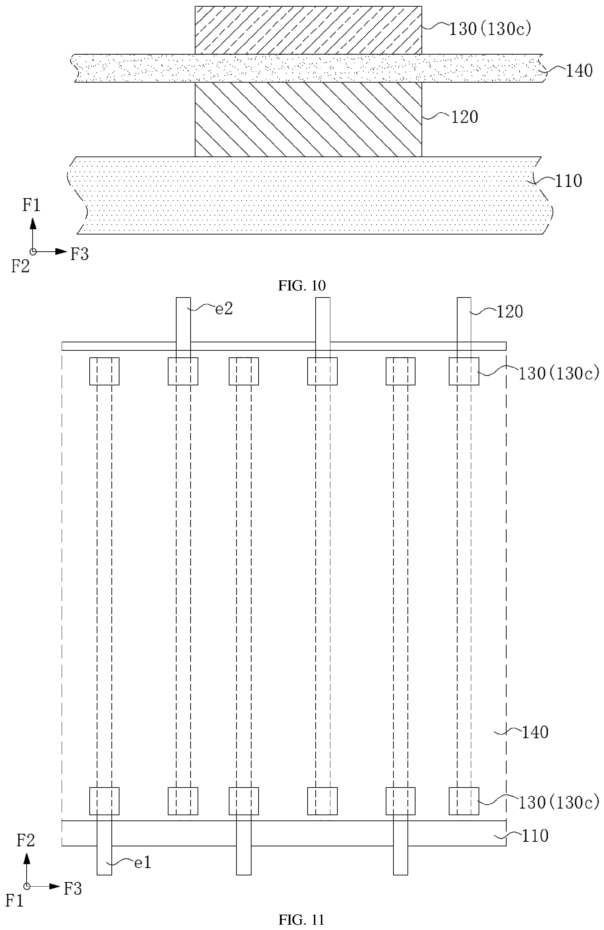

In some embodiments, referring to FIG. 10 and FIG. 11, FIG. 10 shows a schematic side sectional structural view of a part of the structure where the solder strip 120, the adhesive dot 130, the covering film 140, and the solar cell 110 cooperate provided in yet further embodiments of the present disclosure, and FIG. 11 shows a schematic top structural view of a part of the structure where the solder strip 120, the adhesive dot 130, the covering film 140, and the solar cell 110 cooperate provided in further embodiments of the present disclosure. Along the first direction, the third target adhesive dot 130c is completely located on the side of the corresponding covering film 140 away from the solar cell 110. Certainly, along the first direction, it is also possible that a part of the third target adhesive dot 130c is located on the side of the corresponding covering film 140 away from the solar cell 110, and the other part of the third target adhesive dot is in contact with the solder strip 120 or the solar cell 110, and in this case, the third target adhesive dot 130c is located in an edge region of the covering film 140.

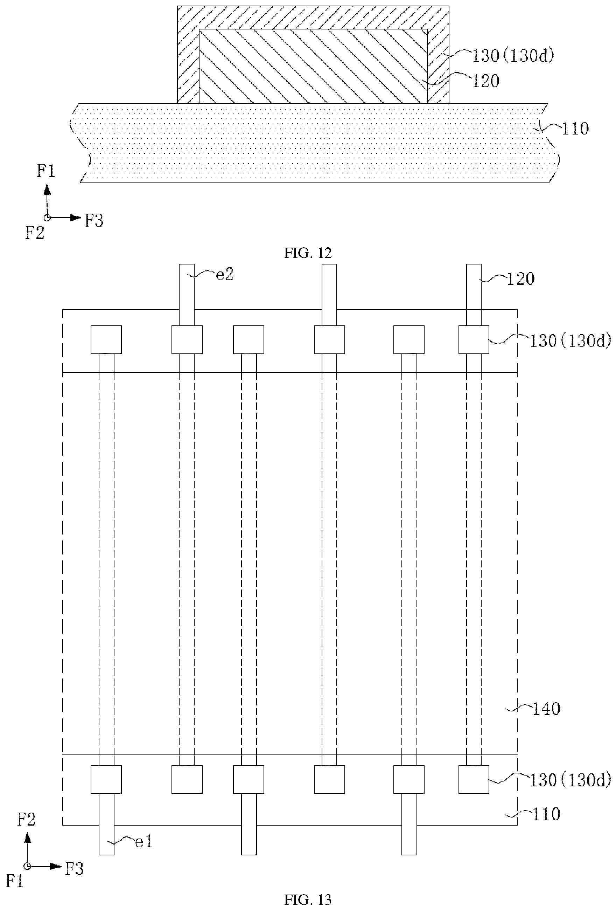

In some embodiments, referring to FIG. 12 and FIG. 13, FIG. 12 shows a schematic side sectional structural view of a part of the structure where the solder strip 120, the adhesive dot 130, the covering film 140, and the solar cell 110 cooperate provided in further embodiments of the present disclosure, and FIG. 13 shows a schematic top structural view of a part of the structure where the solder strip 120, the adhesive dot 130, the covering film 140, and the solar cell 110 cooperate provided in further embodiments of the present disclosure. The fourth target adhesive dot 130d can be located on a side of the solder strip 120 and in contact with the solar cell 110, and the fourth target adhesive dot 130d and the corresponding covering film 140 are independent from each other. Certainly, in further embodiments, the covering film 140 can alternatively cover the fourth target adhesive dot 130d, and a side of the fourth target adhesive dot 130d away from the solar cell 110 is in contact with the covering film 140, which is not limited herein.

Thus, by providing the third target adhesive dot, the covering film and the solder strip can be fixed simultaneously, so that the bonding force of the covering film on the solder strip can be further increased in conjunction with the covering film, thereby improving the reliability of the electrical connection between the solder strip and the solar cell. In addition, during fabrication, transportation and use of the photovoltaic module, the photovoltaic module may experience various mechanical stresses (e.g., pressure during lamination, material expansion and contraction caused by temperature changes, or the like). The third target adhesive dot can be fitted with the covering film to serve as a support point, and absorbs and disperses the stresses, thereby decreasing the situation that the solder strip moves due to insufficient soldering and desoldering between the solder strip and the solar cell. By providing the fourth target adhesive dot, the arrangement sequence of the adhesive dot and the covering film can be more flexible, the photovoltaic module can be manufactured more flexibly, and reliability between the solder strip and the solar cell can be improved. In addition, in the case where the fourth target adhesive dot and the covering film are independent of each other, the photovoltaic modules with different thicknesses can be obtained by controlling sizes of the fourth target adhesive dot and the covering film in the first direction.

Therefore, the solder strips, the adhesive dots, and the covering film can be arranged in different preset sequences through the first target adhesive dot, the second target adhesive dot, the third target adhesive dot, and the fourth target adhesive dot illustrated in some embodiments, so that a fixed structure with improved position stability of the solder strip to different degrees and in different modes is formed.

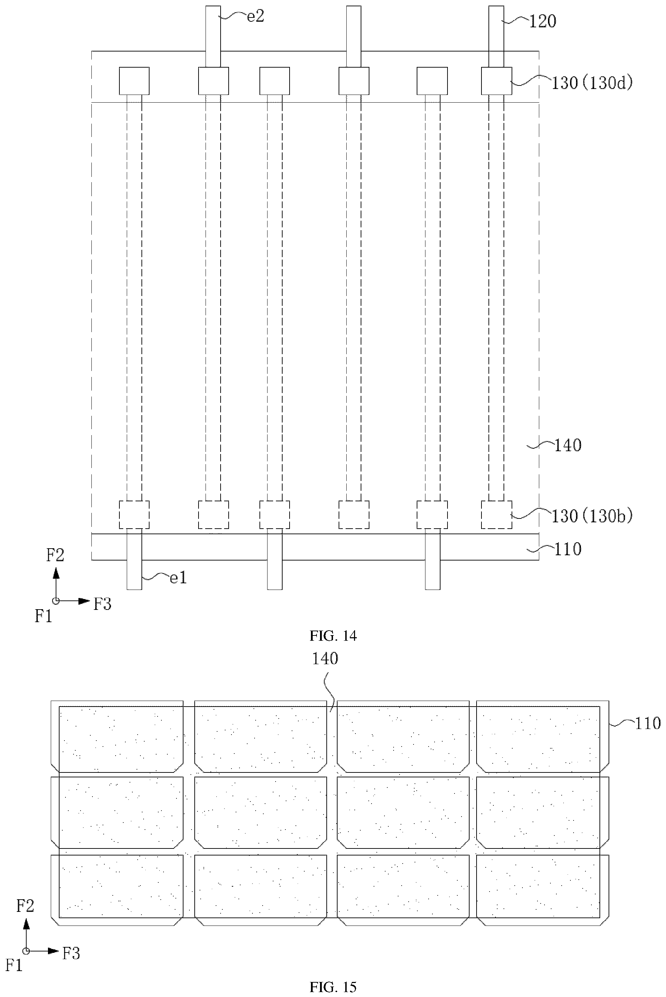

It can be understood that at least two of the first target adhesive dot, the second target adhesive dot, the third target adhesive dot, and the fourth target adhesive dot can be used in cooperation with each other. Taking FIG. 14 as an example, FIG. 14 shows a schematic top structural view of a part of the structure where the solder strip, the adhesive dot, the covering film, and the solar cell cooperate provided in further embodiments of the present disclosure. The second target adhesive dot and the fourth target adhesive dot can be used in combination, which is not limited herein. Therefore, the target adhesive dots with different types cooperate with each other, which is favorable for overall forming a structure with higher reliability by mutual cooperation in different modes.

In some embodiments, for the same target sides of all the solar cells, one covering film is provided, and an orthographic projection of at least a part of the solder strip on the reference plane and an orthographic projection of the corresponding covering film on the reference plane have an overlapped projection. Alternatively, for the same target sides of all the solar cells, a plurality of covering films are provided, and each covering film covers at least one solar cell, all of the covering films are not overlapped with each other, and an orthographic projection of at least a part of the solder strip on the reference plane and the orthographic projection of the corresponding covering film on the reference plane have an overlapped projection. Alternatively, a plurality of covering films are provided for the same target sides of all the solar cells, all covering films and all solar cells are arranged in one-to-one correspondence, and an orthographic projection of at least a part of the solder strip on the reference plane and the orthographic projection of the corresponding covering film on the reference plane have an overlapped projection.

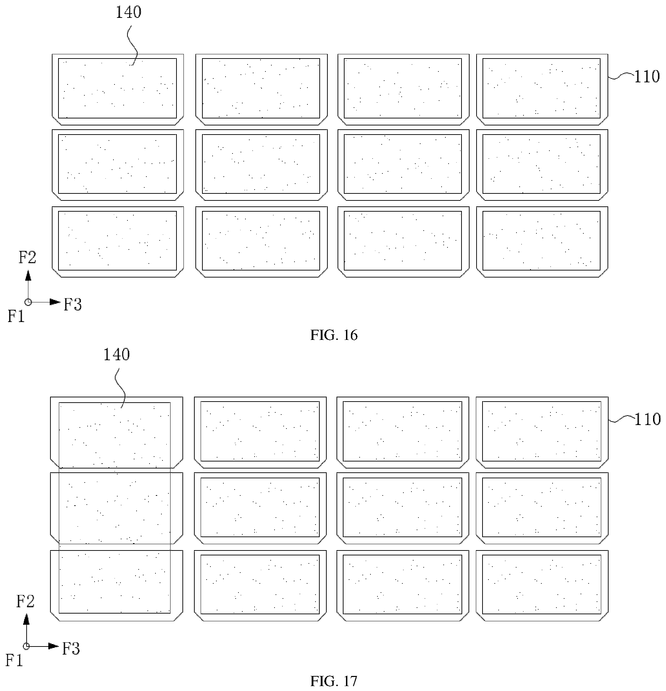

In some embodiments, referring to FIG. 15 to FIG. 17, in order to conveniently show a relationship between the covering film 140 and the plurality of solar cells 110, the solder strip 120 and the adhesive dot 130 are omitted in FIG. 15 to FIG. 17. FIG. 15 illustrates the case where one covering film 140 is provided on the same target side. FIG. 16 illustrates the case where a plurality of covering films 140 are provided in one-to-one correspondence to the plurality of solar cells 110 on the same target side. FIG. 17 illustrates the case where one covering film 140 covers one solar cell 110 and one covering film 140 covers three solar cells 110 on the same target side. For example, in the case illustrated in FIG. 16, the solder strips 120, the adhesive dots 130, and the covering film 140 can be arranged in the preset sequence for each solar cell 110; or the solder strips 120 and the adhesive dots 130 are first arranged on each solar cell 110, and then the covering films 140 are respectively arranged on the solar cells 110. A corresponding arrangement can be performed according to structural forms and positions of the adhesive dots 130, which is not limited herein.

In the case where a plurality of solar cells share one covering film, when an external force or an internal stress (such as material expansion and contraction caused by a temperature change) is applied, the shared covering film can distribute the force to the plurality of solar cells more uniformly, so that the pressure borne by each solar cell is relatively small, and the risk that the single solar cell is damaged due to a local overlarge stress is reduced. Meanwhile, manufacturing steps of the photovoltaic module can be saved, and the manufacturing efficiency is improved.

In the case where each solar cell is correspondingly covered with one covering film, the independent covering film on each solar cell can independently buffer and disperse the external force. Such an independent buffer mechanism enables each solar cell to respond to the external force according to the characteristic and the state of the covering film thereof, and a probability of damage of the solar cell is reduced. For example, even if the covering film on one solar cell is locally deformed after being impacted, the covering films of other solar cells and the solar cells can still work normally and are not influenced too much. The independent covering film can also better accommodate variations in each solar cell when facing the internal stress (such as the thermal expansion and contraction of the solar cell due to the temperature change). Since the covering film of each solar cell is independent, the covering films can be correspondingly adjusted according to change of sizes of the solar cells, which can reduce internal force concentration generated by a difference of the thermal expansion coefficients of the solar cells, thereby reducing the risk that the solar cells are pressed or pulled against each other to be damaged.

In the case where one covering film covers a plurality of solar cells and one covering film covers one solar cell, the advantages of the case where "a plurality of solar cells share one covering film" and the case where "each solar cell is correspondingly covered with one covering film" can be achieved at the same time.

Therefore, different film covering modes can be flexibly configured or combined according to specific use conditions, so that an improvement can be performed depending on stress conditions at different positions, which is not limited herein.

In some embodiments, each solder strip corresponds to a plurality of adhesive dots. Orthographic projections of the plurality of adhesive dots on the reference plane and the orthographic projection of the corresponding solder strip on the reference plane have an overlapped projection.

In some embodiments, referring to FIG. 3 to FIG. 6, FIG. 9, FIG. 11, FIG. 13 and FIG. 14, the case where each solder strip 120 corresponds to two adhesive dots 130 is illustrated.

Thus, by arranging the plurality of adhesive dots, the bonding effect on the solder strip can be further improved, thereby further improving the reliability of the electrical connection between the solder strip and the solar cell.

In some embodiments, the solder strip has a first end portion and a second end portion oppositely arranged along a lengthwise direction of the solder strip. For the plurality of adhesive dots, an orthographic projection of one of the plurality of adhesive dots on the reference plane and an orthographic projection of the first end portion of the corresponding solder strip on the reference plane have an overlapped projection; and an orthographic projection of another adhesive dot on the reference plane and an orthographic projection of the second end portion of the corresponding solder strip on the reference plane have an overlapped projection.

In some embodiments, referring to FIG. 3 to FIG. 6, FIG. 9, FIG. 11, FIG. 13 and FIG. 14, the case where each solder strip 120 corresponds to two adhesive dots 130 is illustrated, the two adhesive dots 130 being respectively located at the corresponding first end portion e1 and the corresponding second end portion e2. The lengthwise direction of the solder strip 120 is a second direction illustrated in the drawing, and the second direction and the first direction are perpendicular to each other.

Thus, since the two adhesive dots are respectively arranged at the corresponding two end portions of the solder strip in the lengthwise direction, the movement of the solder strip in the lengthwise direction can be limited effectively, and the risk that the solder strip is deformed due to the thermal stress can be reduced. When the photovoltaic module is subjected to a stretching force in the lengthwise direction of the solder strip, for example, the photovoltaic module can be stretched by a mounting structure during mounting, or a longitudinal tension can be generated due to improper fixing during transportation, the adhesive dots at the two ends of the solder strip can more effectively resist the stretching force. Meanwhile, the adhesive dots arranged corresponding to the two ends of the solder strip can also change the stress distribution under longitudinal stressing. In the absence of the adhesive dots for fixing, the stretching force is concentrated at a connection part between the solder strip and the solar cell, which easily causes connection loosening or solar cell cracking. By arranging the corresponding adhesive dots, the stretching force can be dispersed to bonding interfaces of the adhesive dots and the solar cell and bonding interfaces of the adhesive dots and the solder strips. Such a stress dispersing mechanism allows each local stress to be reduced, thereby reducing the risk of damage due to stress concentration. In a direction perpendicular to the lengthwise direction of the solder strip (e.g., a third direction F3 illustrated in the drawing), when the photovoltaic module is subjected to a shearing force, such as a transverse wind pressure generated on the surface of the module during a strong wind, or a transverse friction force applied during transportation, the adhesive dots corresponding to the two ends of the solder strip can play a role of resisting the shearing force.

It should be noted that, referring to FIG. 3 to FIG. 6, FIG. 9, FIG. 11, FIG. 13, and FIG. 14, the first end portion e1 and the second end portion e2 of the solder strip 120 are relative to each other. The adhesive dot 130 corresponding to the first end portion e1 can directly face an edge region of the first end portion e1 in the first direction, or directly face a non-edge region of the first end portion e1 in the first direction. The adhesive dot 130 corresponding to the second end portion e2 can also be understood by referring to the adhesive dot 130 corresponding to the first end portion e1, which is not repeated herein. The solder strips 120 on the solar cells 110 are arranged differently according to types of the solar cells 110 and different electrical connection manners of the solar cells 110. According to FIG. 3 to FIG. 6, FIG. 9, FIG. 11, FIG. 13, and FIG. 14, the plurality of solder strips 120 are illustrated to be arranged at intervals in the third direction, and the first direction, the second direction, and the third direction are perpendicular to each other. For the plurality of solder strips 120, parts of the second end portions e2 of partial solder strips 120 extend out from one side of the solar cell 110 in the second direction, and parts of the first end portions e1 of another part of the solder strips 120 extend out from the other side of the solar cell 110 in the second direction. In this case, for the solder strip 120 in which a part of the second end portion e2 extends out from the solar cell 110, the adhesive dot 130 corresponding to the second end portion e2 of the solder strip 120 directly faces the non-edge region of the second end portion e2 in the first direction. For the solder strip 120 in which a part of the first end portion e1 extends out from the solar cell 110, the adhesive dot 130 corresponding to the first end portion e1 of the solder strip 120 directly faces the non-edge region of the first end portion e1 in the first direction. Positions of the adhesive dots 130 arranged corresponding to the first end portion e1 and the second end portion e2 of the solder strip 120 can be determined according to a position of the solder strip 120 relative to the solar cell 110, which are not limited herein.

Further, in some embodiments, with continued reference to FIG. 3, the adhesive dots 130 arranged corresponding to the first end portion e1 can be arranged at intervals along the third direction, and the adhesive dots 130 arranged corresponding to the second end portion e2 can be arranged at intervals along the third direction. In this case, an extending direction of a connecting line of centers of the adhesive dots 130 corresponding to the first end portion e1 is parallel to the third direction, and an extending direction of a connecting line of centers of the adhesive dots 130 corresponding to the second end portion e2 is parallel to the third direction.

Such an arrangement of the adhesive dots is beneficial to more uniformly dispersing the stress, and makes the position change of each solder strip relatively small when the solder strip is subjected to the external force, thereby reducing the change of contact resistance caused by the displacement of the solder strip. Meanwhile, the adhesive dots can be conveniently formed by screen printing.

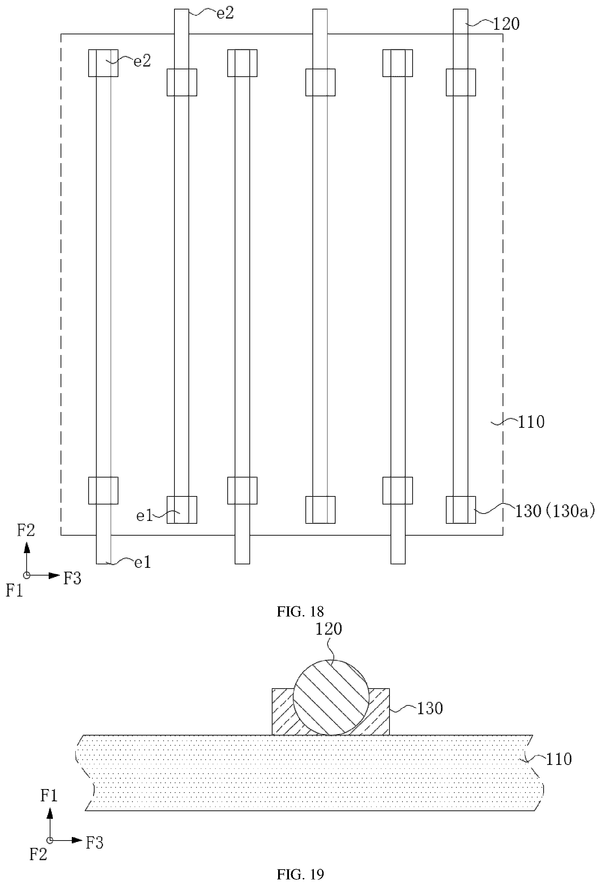

Certainly, in further embodiments, referring to FIG. 18, FIG. 18 shows a schematic top structural view of a part of the structure where the solder strip 120, the adhesive dot 130, and the solar cell 110 cooperate provided in further embodiments of the present disclosure. The adhesive dots 130 arranged corresponding to the first end portion e1 can be staggered along the third direction, and the adhesive dots 130 arranged corresponding to the second end portion e2 can be staggered along the third direction. In this case, the connecting line of the centers of the adhesive dots 130 corresponding to the first end portion e1 is substantially a broken line, and the connecting line of the centers of the adhesive dots 130 corresponding to the second end portion e2 is substantially a broken line.

Such an arrangement of the adhesive dots can provide resistances in different directions, so that a mutual-restraining structure is formed between the solder strips. For example, when a torsional force is applied, some adhesive dots are subjected to a stretching force, and other adhesive dots are subjected to a compressive force, so that the interaction can effectively counteract the torsional force, improve excessive distortion between the solder strip and the solar cell, and protect the structural integrity of the photovoltaic module. Thus, the torsion resisting performance of the whole photovoltaic module can be enhanced. Meanwhile, the stress can be dispersed to a surrounding region through different transmission paths, so that the local stress can be better dispersed, thereby reducing the risk of cracking of the solar cell and damage to the solder strip. In addition, the tension of the connection between the solder strip and another solar cell is also favorably increased, so that the risk of deviation of the solder strip at an edge of the solar cell is further reduced.

In some embodiments, the covering film is configured into a single-layer structure, and a pre-cross-linking degree of the covering film is 20% to 50%. Alternatively, the covering film is configured into a multilayer structure, the covering film includes a plurality of stacked sub-covering films, and a pre-cross-linking degree of a sub-covering film in the plurality of sub-covering films closest to the solar cell is 20% to 50%.

The pre-cross-linking degree is a progress degree of the cross-linking reaction during preparation of the covering film. The cross-linking reaction refers to a process of forming a three-dimensional network structure by connecting polymer molecular chains with each other through chemical bonds (such as covalent bonds). The pre-cross-linking degree can be intuitively understood as a relative quantity of cross-linking bonds formed at a particular stage (usually before final shaping of a material) or a perfection degree of the cross-linked structure. On the molecular level, a high pre-cross-linking degree means that more molecular chains are connected through cross-linking bonds to form a relatively compact three-dimensional network. The pre-cross-linking degree can be expressed by a proportion of reacted functional groups that can form the cross-linking bonds. Assuming that in a polymer system containing double bonds, all double bonds can participate in the cross-linking reaction. There are 100 double bonds in the initial system, and 60 double bonds participate in the cross-linking reaction during the reaction. Thus, the pre-cross-linking degree can be expressed as 60%.

For example, in the case where the covering film is configured into a single-layer structure, the pre-cross-linking degree of the covering film can be 20%, 30%, 32%, 35%, 37%, 42%, 45%, 48%, or 50%, and the pre-cross-linking degree of the covering film can be any value of 20% to 50%. In the case where the covering film is configured into a multilayer structure, the pre-cross-linking degree of the sub-covering film among the plurality of sub-covering films closest to the solar cell can be 20%, 30%, 32%, 35%, 37%, 42%, 45%, 48%, or 50%, and the pre-cross-linking degree of the sub-covering film closest to the solar cell can be any value of 20% to 50%, which is not limited herein.

The pre-cross-linking degree is closely related to physical and chemical performances of the material of the covering film. The high pre-cross-linking degree generally results in increased hardness and decreased elasticity of the material. Since the cross-linked structure limits stretching and deformation of the molecular chain, the material is more rigid. For example, when a plastic covering film having high hardness is produced, the pre-cross-linking degree is suitably increased. Meanwhile, the pre-cross-linking degree also influences thermal stability, solvent resistance, and other performances of the material. A material with a high pre-cross-linking degree is less susceptible to softening and deformation at a high temperature, and the cross-linked structure is damaged at an excessively high temperature.

Therefore, in the case where the covering film is configured into a single-layer structure, by controlling the pre-cross-linking degree of the covering film, the processing operation is facilitated, the processing time is shortened, a balance of strength and toughness is better achieved, and the certain supporting performance and buffering performance are generated. In the case that the covering film is configured into a multi-layer structure, by controlling the sub-covering film closest to the solar cell, good initial mechanical protection can be provided for the solar cell. Meanwhile, due to its certain flexibility, when the solar cell undergoes slight expansion or contraction, such as caused by the temperature change, it can adapt to this change to avoid an excessive pressure on the solar cell. The rest of sub-covering films can be configured more flexibly, which provide an additional protection function for the solar cell. For example, the remaining sub-covering films can have better chemical protection performances such as weather resistance and corrosion resistance, and block damage of ultraviolet rays, moisture, chemical gas, or the like, to the solar cell and an inner-layer covering film. The layered protection mechanism can prolong service lives of the whole covering film structure and the solar cell. In addition, if a certain sub-covering film has a quality problem in the processing process, the multi-layer structure is beneficial to isolating the problem. For example, processing defects of an outer-layer covering film cannot directly affect the sub-covering film closest to the solar cell and the solar cell, so that the risk of scrapping the whole photovoltaic module due to the local quality problem is reduced, and the yield of products is improved.

In some embodiments, with continued reference to FIG. 4 to FIG. 6, FIG. 9, FIG. 11, FIG. 13, and FIG. 14, for the same target side of the same solar cell 110, the orthographic projection of each solder strip 120 on the reference plane and the orthographic projection of the corresponding covering film 140 on the reference plane have an overlapped projection.

Therefore, each solder strip is provided with a certain bonding force by the corresponding covering film, and therefore, the reliability of the electrical connection between the solder strip and the solar cell can be further improved.

Certainly, in some other embodiments, it is also possible that for the same target side of the same solar cell, the orthographic projections of a part of the solder strips on the reference plane and the orthographic projection of the corresponding covering film on the reference plane have an overlapped projection, which is not limited herein.

In some embodiments, a lowest torque value ML of the covering film satisfies: 0.1≤ML≤0.8.

In some embodiments, the lowest torque value ML of the covering film can be 0.1, 0.2, 0.3, 0.6, or 0.8. The lowest torque value ML of the covering film can be any value between 0.1 and 0.8, and is not limited herein. For example, the lowest torque value ML of the covering film satisfies: 0.3≤ML≤0.8.

The torque value of the covering film refers to a torsional moment applied to the covering film when the covering film is subjected to a twisting operation.

As such, by controlling the lowest torque value of the covering film, the covering film has relatively low fluidity, so that the covering film can better provide the bonding force acting on the solder strip, while the situation that a packaging adhesive flows to the area between the solder strip and the solar cell in a subsequent laminating process can be further decreased, thereby further improving welding effect. In addition, the situation that undissolved bubbles occur can be decreased, thereby decreasing the appearance defect and the reliability failure.

In some embodiments, a temperature of the covering film during application is from 100°C to 135°C. In some embodiments, the temperature of the covering film during application can be 100°C, 110°C, 120°C, 130°C or 135°C. The temperature of the covering film during application can be any value between 100°C and 135°C, and is not limited herein.

Thus, by controlling the temperature of the covering film during application, the molecular chains of the material of the covering film can be adjusted to a certain degree. This temperature range is favorable for making the molecular chains of the material more compliant, thereby enhancing flexibility of the covering film. In the subsequent use process, the covering film with good flexibility can better adapt to tiny deformation of the solar cell under the conditions of temperature change, mechanical stress, or the like, thus reducing the risk of damage to the solar cell due to the rigidity of the material, such as cracking. Meanwhile, the appropriate temperature can increase the bonding performance between the covering film and the solar cell. In this temperature interval, the material of the covering film can undergo some physical and chemical changes, thereby improving the bonding force of the covering film on the solder strip.

In some embodiments, a thickness of the covering film is from 50 µm to 500 µm. In some embodiments, the thickness of the covering film can be 50 µm, 70 µm, 80 µm, 90 µm, 110 µm, 150 µm, 200 µm, 300 µm, 400 µm, or 500 µm. The thickness of the covering film can be any value between 50 µm and 500 µm, and is not limited herein.

Therefore, by controlling the thickness of the covering film, the covering film is convenient to be manufactured while having a certain mechanical performance.

In some embodiments, the adhesive dots are cured during forming the solar cell string, and a cross-linking degree of the cured adhesive dots is larger than 90%.

The adhesive dots can be arranged at corresponding positions through an adhesive dispensing process. According to different materials, the adhesive dots can be cured through processes such as photocuring. The curing step can be determined according to an arrangement sequence of the adhesive dots. For example, when the adhesive dots are arranged prior to the solder strip, the curing step can be performed after arranging the solder strip, or the curing step can be performed after arranging the covering film, which is not limited herein.

The cross-linking degree of the cured adhesive dots refers to the degree of a network structure formed by mutually connecting polymer molecular chains of the adhesive dots through chemical bonds (such as covalent bonds). In some embodiments, the cross-linking degree of the cured adhesive dots can be 91%, 92%, 93%, 94%, 95%, 96%, or 99%.

Thus, a highly cross-linked network structure is formed among the molecular chains of the adhesive dots. Such a structure causes the adhesive dots to have high strength and hardness, and can better withstand the external pressure and tension. During use of the photovoltaic module, for example, when the photovoltaic module is subjected to wind blowing, a vibration, a temperature change, or the like, the adhesive dots with a high cross-linking degree can firmly bond the solder strips or other components, thus decreasing shifting or falling-off conditions, and providing reliable mechanical stability for the photovoltaic module. Meanwhile, the highly-cross-linked adhesive dots have a relatively low creeping tendency, that is, they are not prone to be slowly deformed under the action of the external force, so that the solder strip can be more effectively fixed, and the reliability of the photovoltaic module is improved.

In some embodiments, Tg of the adhesive dot is greater than or equal to 59.40°C. Tg refers to a temperature at which the adhesive dot is transformed from a glassy state to a high-condensed state.

In some embodiments, Tg of the adhesive dot can be 59.40°C, 60°C, 65°C, 70°C or 80°C.

Thus, the adhesive dot can maintain its glassy state or the performance close to the glassy state at a relatively high temperature. This means that the adhesive dots do not easily soften or flow in a high temperature environment. For example, the adhesive dots can still stably bond the solder strips or other components under hot weather conditions or when the temperature inside the photovoltaic module is increased due to heat generated by working.

In some embodiments, the solder strip includes at least one of a round wire solder strip, a triangular solder strip, a flat solder strip, and a special-shaped solder strip.

The round wire solder strip has a uniform circular section, which enables the current to be distributed evenly when it travels therein. According to an electrical principle, when a round conductor transmits a current, a current density is distributed on the section uniformly, so that the current concentration phenomenon can be effectively reduced, thereby reducing the resistance loss. For example, in the photovoltaic module, such uniform current transmission helps to improve the efficiency of the electrical connection between the solar cells, reduce the heat generation issue caused by an excessively high local resistance, and improve the overall power generation performance of the photovoltaic module.

Due to its shape characteristics, the triangular solder strip can play a certain role in capturing and guiding light in the photovoltaic module. When the light irradiates the surface of the photovoltaic module, edges of the triangle can change a propagation direction of the light, and a part of light which can be reflected or scattered originally is reflected to the solar cell, so that a light receiving area and a light absorption efficiency of the solar cell are increased. The triangular structure makes the contact area between the solder strip and the solar cell relatively large, and good mechanical bonding can be formed on the contact surface. The mechanical bonding force facilitates bonding of the solder strip on the solar cell, thus reducing possibility of shifting of the solder strip during production and use.

The flat solder strip is substantially in a sheet shape. A contact area between the flat solder strip and the solar cell is relatively large, which is favorable for improving the connection stability between the flat solder strip and the solar cell. In an electrical connection aspect, the relatively large contact area can reduce contact resistance to ensure that the current can be smoothly transmitted between the solar cell and the solder strip. Meanwhile, in a mechanical aspect, the flat solder strip can be better attached to the surface of the solar cell to resist shifting under the action of the external force, thereby providing a more reliable guarantee for the connection between the solar cells.

A shape of the special-shaped solder strip can be customized and designed according to specific application requirements. For example, the shape of the special-shaped solder strip can be designed to have a special reflective surface or refractive surface to optimize the distribution of light on the solar cell, and improve the light absorption efficiency. Meanwhile, in an electrical performance aspect, the current distribution can be adjusted through a special-shaped structure, for example, a wider conductive part is designed in a region needing a high current density, and special electrical connection requirements are met, thereby improving the overall performance of the photovoltaic module.

In some embodiments, referring to FIG. 2 to FIG. 14, the solder strip 120 is illustrated as a flat solder strip 120. Referring to FIG. 19, FIG. 19 shows a schematic side sectional structural view of a part of the structure where the solder strip 120, the adhesive dot 130, and the solar cell 110 cooperate provided in some embodiments of the present disclosure, and the solder strip 120 is illustrated as a round wire solder strip 120. In FIG. 19, the covering film 140 is omitted.

Thus, the shape of the solder strip can be set according to use requirements, which is not limited herein.

In some embodiments, the adhesive dots include a first sub-adhesive dot and a second sub-adhesive dot that are independent of each other. An orthographic projection of the first sub-adhesive dot on the reference plane is a first projection, and an orthographic projection of the second sub-adhesive dot on the reference plane is a second projection. The first projection and the second projection corresponding to the same adhesive dot are respectively located on two sides of a central axis of the orthographic projection of the corresponding solder strip on the reference plane, and both the first projection and the second projection have overlapped projections relative to the orthographic projection of the corresponding solder strip on the reference plane. An extending direction of the central axis of the orthographic projection of the solder strip on the reference plane is parallel to the lengthwise direction of the solder strip.

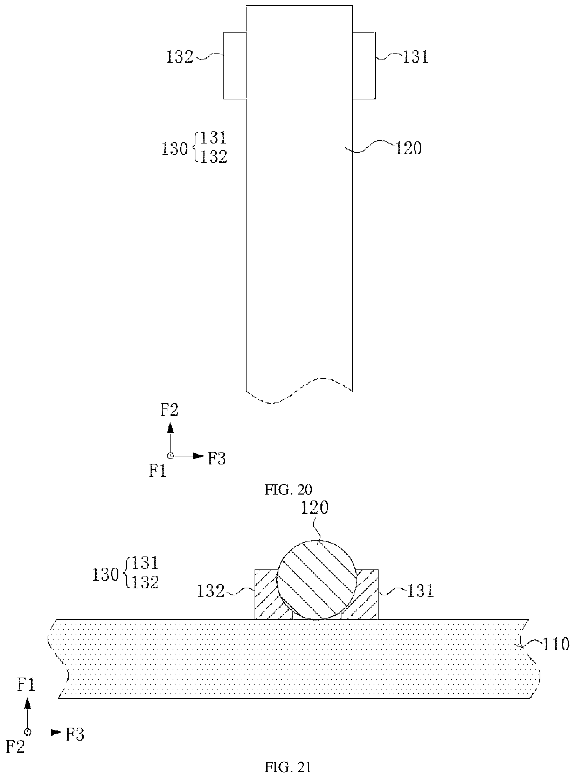

In some embodiments, referring to FIG. 20 and FIG. 21, the covering film 140 is omitted in FIG. 21. FIG. 20 shows the case where the solder strip 120 is the flat solder strip 120, and FIG. 21 shows the case where the solder strip 120 is the round wire solder fillet 120. Certainly, in some other embodiments, the adhesive dot 130 on the covering film 140 can be configured to include the first sub-adhesive dot 131 and the second sub-adhesive dot 132 independent of each other, which is not limited herein.

Thus, since the two sides of the solder strip are fixed and limited by the adhesive dots, the risk of deviation of the solder strip in the laminating process is reduced, and the reliability of the electrical connection between the solder strip and the solar cell in the use process of the photovoltaic module is further improved favorably. Meanwhile, since the first sub-adhesive dot and the second sub-adhesive dot substantially correspond to the two sides of the solder strip, in the case of adopting the arrangement of the adhesive dot 130 illustrated in FIG. 20 and FIG. 21, the adhesive dots are more easily cured, and the time for curing the adhesive dots is shorter, thereby being beneficial to improving the manufacturing efficiency of the photovoltaic module. For example, when the adhesive dots are made of photocurable adhesive, the curing time for curing the adhesive dots using UV light can be shortened.

In some embodiments, the shapes of the orthographic projections of all the adhesive dots on the reference plane include at least one of a circle, an ellipse, a rectangle, a long strip, or a frame.

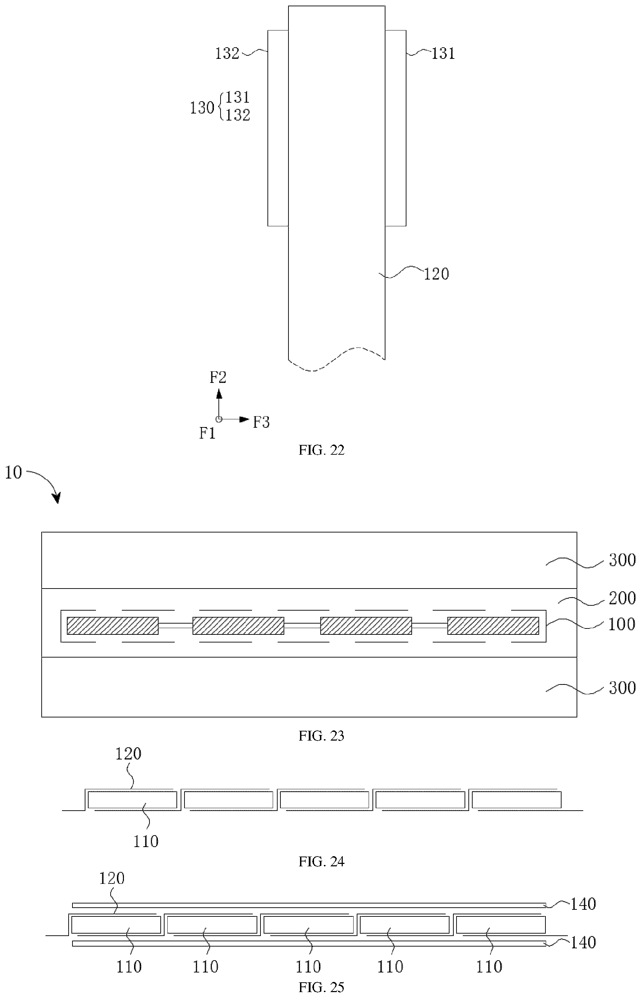

In some embodiments, in the case illustrated in FIG. 3 to FIG. 6, FIG. 9, FIG. 11, FIG. 13, FIG. 14, and FIG. 18, the orthogonal projection of the adhesive dot 130 on the reference plane is rectangular. In some embodiments, referring to FIG. 22, FIG. 22 shows a schematic top structural view of a part of the structure where the solder strip 120 and the adhesive dot 130 cooperate provided in further embodiments of the present disclosure. In FIG. 22, the adhesive dot 130 includes the first sub-adhesive dot 131 and the second sub-adhesive dot 132, and the orthographic projections of the first sub-adhesive dot 131 and the second sub-adhesive dot 132 on the reference plane are both in a long strip shape. The orthographic projections of all the adhesive dots 130 on the reference plane can have one same shape, or have more different shapes, which is not limited herein. In some embodiments, the frame-shaped adhesive dots 130 need reduced usage amount of adhesive dot 130 compared to other forms of adhesive dots 130.

Therefore, corresponding configurations of the adhesive dots can be flexibly combined and configured according to stress on the solder strips at different positions and use requirements of the photovoltaic module, so that the reliability of the photovoltaic module is improved to different degrees and in different modes. In the case of using a printing screen to print the adhesive dots, meshes of the printing screen are also set according to the corresponding configuration of the adhesive dots, which is not limited herein.

In some embodiments, with continued reference to FIG. 3, the tension between the solder strip 120, the adhesive dot 130, and the solar cell 110 is greater than or equal to 0.3 N. For example, the corresponding tension can be controlled by configuring sizes and materials of the adhesive dots 130, which is not limited.

For example, taking FIG. 4 as an example, in the case where the solder strip 120 is a flat solder strip 120, the size of the solder strip 120 in the third direction can be 0.4 mm to 2 mm, the size of the adhesive dot 130 in the second direction can be 0.4 mm, and the size of the adhesive dot 130 in the third direction can be 1 mm to 4 mm.

In some embodiments, taking FIG. 20 as an example, a distance between the first sub-adhesive dot 131 and the second sub-adhesive dot 132 along the third direction is greater than or equal to 0.4 mm, sizes of the first sub-adhesive dot 131 and the second sub-adhesive dot 132 along the second direction can both be 0.4 mm, and sizes of the first sub-adhesive dot 131 and the second sub-adhesive dot 132 along the third direction can both be 1 mm to 4 mm. A maximum value of the distance between the first sub-adhesive dot 131 and the second sub-adhesive dot 132 in the third direction can be determined according to the sizes of the solder strip 120, the first sub-adhesive dot 131, and the second sub-adhesive dot 132 in the third direction, which is not limited herein.

In some embodiments, taking FIG. 22 as an example, the distance between the first sub-adhesive dot 131 and the second sub-adhesive dot 132 along the third direction is greater than or equal to 0.4 mm, the sizes of the first sub-adhesive dot 131 and the second sub-adhesive dot 132 along the second direction can both be 2 mm, and the sizes of the first sub-adhesive dot 131 and the second sub-adhesive dot 132 along the third direction can both be 4 mm to 10 mm. The maximum value of the distance between the first sub-adhesive dot 131 and the second sub-adhesive dot 132 in the third direction can be determined according to the sizes of the solder strip 120, the first sub-adhesive dot 131, and the second sub-adhesive dot 132 in the third direction, which is not limited herein.

In some embodiments, taking FIG. 21 as an example, in the case where the solder strip 120 is a round wire solder strip 120, the size of the solder strip 120 in the third direction (i.e., a diameter of the solder strip 120) can be 0.18 mm to 0.3 mm. The distance between the first sub-adhesive dot 131 and the second sub-adhesive dot 132 along the third direction is greater than or equal to 0.2 mm. The maximum value of the distance between the first sub-adhesive dot 131 and the second sub-adhesive dot 132 in the third direction can be determined according to the sizes of the solder strip 120, the first sub-adhesive dot 131, and the second sub-adhesive dot 132 in the third direction, which is not limited herein.

In some embodiments, taking FIG. 19 as an example, in the case where the solder strip 120 is a round wire solder strip 120, the size of the solder strip 120 in the third direction (i.e., the diameter of the solder strip 120) can be 0.18 mm to 0.3 mm. The size of the adhesive dot 130 in the second direction can be 0.2 mm, and the size of the adhesive dot 130 in the third direction can be 1.5 mm to 3 mm.

Thus, by controlling the configuration and size of the solder strip and the adhesive dot, the solder strip can have a certain tension, and the risk of insufficient soldering between the solder strip and the solar cell caused by adhesive dot permeation can be reduced.

In some embodiments, before the step S120, the manufacturing method includes: printing an insulating adhesive layer on the solar cell and curing the insulating adhesive layer.

For example, a corresponding insulation pattern is designed according to electrode distribution and insulation requirements of the solar cell, and a corresponding screen is manufactured according to the insulation pattern. The insulating adhesive layer is formed at a corresponding position on the solar cell through screen printing. Then, the insulating adhesive layer is cured.

Therefore, short circuits between the solar cells and between the solar cell and other assembly components (such as a metal frame) can be decreased. By printing the insulating adhesive at the corresponding position, effective insulating barriers can be formed between conductive regions of the solar cells, so that the current flows according to a designed circuit path.

In some embodiments, before the step S120, the manufacturing method includes: printing a solder on the solar cell and curing the solder.

For example, a position of the solder is determined according to the electrode distribution of the solar cell, and a corresponding printing template is prepared according to the position of the solder. The solder can be a tin paste that includes mainly tin alloy powders (e.g., tin-silver-copper alloy) and a soldering flux. The printing template is placed above the solar cell, and the solder paste is scraped on the template through a scraper. After printing, the tin paste is deposited on electrodes of the solar cell through openings of the printing template to form a tin paste layer. Then, the tin paste layer is cured.

In some embodiments, after the step S120, the manufacturing method includes: providing a cover plate and an encapsulation layer, and processing the cover plate, the encapsulation layer, and the solar cell string by using a laminating process to form the photovoltaic module.

For example, the cover plate, the encapsulation layer, and the solar cell string can be stacked prior to lamination. Referring to FIG. 23, the encapsulation layer 200 is configured to cover a surface of the solar cell string 100. The cover plate 300 is configured to cover a surface of the encapsulation layer 200 away from the solar cell string 100. Further, the solar cells 110 in a single-piece or multi-piece form are electrically connected to form a plurality of solar cell strings 100 according to the method of forming the solar cell string 100 in any of above embodiments, and the plurality of solar cell strings 100 are electrically connected in series and/or in parallel. The encapsulation layer 200 covers the front and back surfaces of the solar cell 110, so that the photovoltaic module 10 can be obtained.

For example, the encapsulation layer 200 can be an organic encapsulation adhesive film, such as an EVA adhesive film, a POE adhesive film, or a polyethylene terephthalate (PET) adhesive film.

In some embodiments, the cover plate 300 can be a cover plate having a light transmitting function, such as a glass cover plate, a plastic cover plate, or the like.

In some embodiments, a surface of the cover plate 300 facing the encapsulation layer 200 can be a concave-convex surface to increase the utilization rate of incident light.

During the lamination, the lamination temperature can be determined according to a cross-linking temperature of the encapsulation layer, a melting point of the solder described in above embodiments, or the like. In some embodiments, the lamination temperature can be 100°C to 150°C.

As such, during the lamination, the electrical connection between the solder strip and the solar cell can be achieved at the lamination temperature and the lamination pressure, thereby forming the photovoltaic module.

An exemplary method for manufacturing the photovoltaic module according to embodiments of the present disclosure is described in conjunction with processes illustrated in the above embodiments, but the present disclosure is not limited thereto.

As an example, the solar cell is a main busbar-free solar cell. According to types of the solar cells, one type of the solar cells (for example, a TOPCon cell) includes electrodes (i.e., grid fingers) arranged on both the front surface and the back surface, and solder strips are required to be arranged on both the front surface and the back surface of the solar cell, and in this case, the target side of the solar cell is at least one of the front surface side and the back surface side of the solar cell. For another type of the solar cells (such as a BC cell), electrodes (i.e., grid fingers) are arranged on the back surface, solder strips are required to be arranged on the back surface of the solar cell, and in this case, the target side of the solar cell is the back surface side of the solar cell.

In an illustrative embodiment, for example, the front and back surfaces of the solar cell are provided with the electrodes, and the front and back surface sides of the solar cell are both the target sides. Referring to FIG. 24, only the relationship between the solder strip 120 and the solar cell 110 is illustrated in FIG. 24. A first solar cell 110 is arranged on an upper side of the second half of a first solder strip group, the first half of a second solder strip group is arranged on the first solar cell 110, a second solar cell 110 is arranged on an upper side of the second half of the second solder strip group, the first half of a third solder strip group is arranged on the second solar cell 110, a third solar cell 110 is arranged on an upper side of the second half of the third solder strip group, and so on. Each solder strip group includes a plurality of solder strips 120.

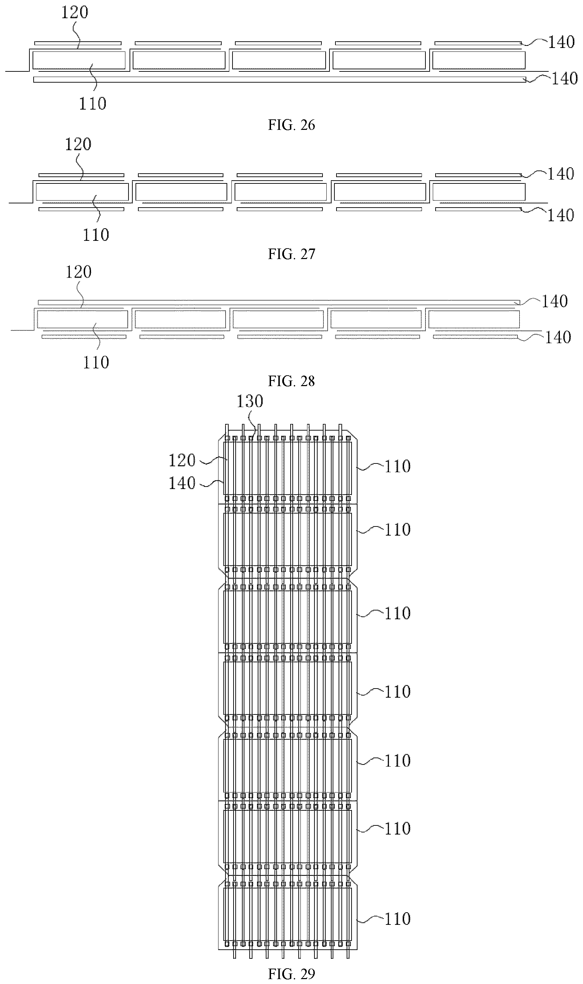

In this process, when the related components are arranged on the target side of the corresponding solar cell, the target side of the solar cell is arranged upwards. The adhesive dots, the solder strips, and the covering film can be arranged in sequence; alternatively, the solder strips, the adhesive dots, and the covering film are arranged in sequence; alternatively, the solder strips, the covering film, and the adhesive dots are arranged in sequence. Certainly, after the corresponding solder strips, adhesive dots, and covering film are arranged for each solar cell, the solar cells are disposed; alternatively, after the solder strips and the adhesive dots are arranged on all the solar cells, the covering film is disposed. As such, different structural forms as illustrated in FIG. 25, FIG. 26, FIG. 27, and FIG. 28 can be formed. In the case illustrated in FIG. 25, the front surface side and the back surface side of the solar cell 110 are both the target sides, and the front surface side and the back surface side of the entire structure is each provided with one covering film 140. In the case illustrated in FIG. 26, the front surface side and the back surface side of the solar cell 110 are both the target sides, the front surface side of the entire structure is provided with a plurality of covering films 140, and the back surface side of the entire structure is provided with one covering film 140. In the case illustrated in FIG. 27, the front surface side and the back surface side of the solar cell 110 are both the target sides, and the front surface side and the back surface side of the entire structure is each provided with a plurality of covering films 140. In the case illustrated in FIG. 28, the front surface side and the back surface side of the solar cell 110 are both the target sides, the front surface side of the entire structure is provided with one covering film 140, and the back surface side of the entire structure is provided with a plurality of covering films 140. The cooperation form of the solder strips 120, the adhesive dots 130, and the covering film 140 can be various cases illustrated in some embodiments described above. The adhesive dots 130 are omitted in FIG. 25 to FIG. 28. The solder strips 120, the adhesive dots 130, and the covering film 140 can be configured according to different cooperation forms, which is not limited herein.

In another exemplary embodiment, for example, the back surface of the solar cell is provided with the electrode, and the back surface side of the solar cell is the target side. Referring to FIG. 29, only the relationship between the solder strip 120 and the solar cell 110 is illustrated in FIG. 29, a plurality of solar cells 110 can be first laid on a corresponding support device, with the back surface of the solar cell 110 facing upwards; and subsequently, a plurality of solder strip groups are placed on the back surfaces of the plurality of solar cells 110, each solder strip group including a plurality of solder strips 120, and the structural form shown in FIG. 29 is formed.

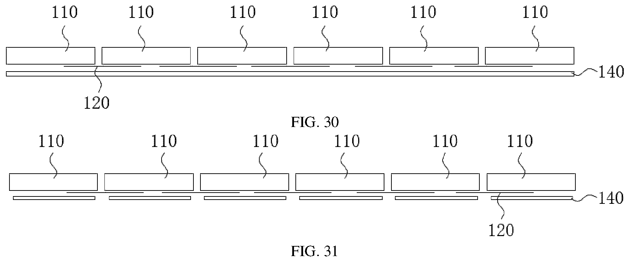

It should be noted that the placement of the solder strip 120 includes, but is not limited to the above situation. Alternatively, it can be the situation where the first half or the second half of the solder strip group is located on the corresponding solar cell 110, that is, the position of each solder strip 120 in the solder strip group relative to the corresponding solar cell 110 is substantially the same. In this process, the arrangement sequence of the adhesive dots 130, the solder strips 120, and the covering film 140 can be understood by referring to the cases illustrated in above embodiments, which is not repeated herein. As such, different structural forms as illustrated in FIG. 30 and FIG. 31 can be formed. In the cases illustrated in FIG. 30 and FIG. 31, the back surface side of the solar cell 110 is the target side. FIG. 30 illustrates the case where one covering film 140 is arranged on the back surface side of the entire structure. FIG. 31 illustrates the case where a plurality of covering films 140 are arranged on the back surface side of the entire structure. The adhesive dots 130 are omitted in FIG. 29 and FIG. 30. In addition, in FIG. 25 to FIG. 28, FIG. 30, and FIG. 31, the relative position relationship between the solder strip 120, the covering film 140, and the solar cell 110 is illustrated.

It can be understood that, in the case where the solar cell is a main busbar-free solar cell, the photovoltaic module can be manufactured by using a low-temperature film covering process. The solder strip can be a low temperature solder strip. A surface layer of the solder strip can be provided with a low melting point alloy or a low melting point metal coating. For example, a melting point of the low melting point alloy or the low melting point metal coating can be 140°C. In this process, since the encapsulation layer is a layer having a buffer performance, the reliability of the electrical connection between the solder strip and the solar cell is affected in the case where the material expands and contracts due to the temperature change. According to embodiments of the present disclosure, by arranging the covering film with different buffer performance from that of the encapsulation layer and using the adhesive dots in cooperation, the position stability of the solder strip relative to the solar cell can be improved, thereby improving the reliability of the electrical connection between the solder strip and the solar cell. In addition, by arranging the covering film, the subsequently arranged encapsulation layer can be relatively thin, which also facilitates a thin design of the photovoltaic module. Thus, according to the manufacturing method illustrated in embodiments of the present disclosure, the reliability of the photovoltaic module can be improved in the processes of a laminating stage, a thermal cycling (TC) reliability test, a use process of the photovoltaic module, a transportation process of the photovoltaic module, or the like.

The technical features of above-mentioned embodiments can be combined arbitrarily. In order to make the description concise, not all possible combinations of the technical features are described in embodiments. However, as long as there is no contradiction in the combination of these technical features, the combinations should be considered as in the scope of the specification.

Above-described embodiments are only several implementations of the present disclosure, and the descriptions are relatively specific and detailed, but they should not be construed as limiting the scope of the present disclosure. It should be understood by those of ordinary skill in the art that various modifications and improvements can be made without departing from the concept of the present disclosure, and all fall within the protection scope of the present disclosure. Therefore, the protection scope of the present disclosure should be subject to the appended claims.

## Claims

1. A method for manufacturing a photovoltaic module (10), comprising:
providing solar cells (110); and
connecting a plurality of solar cells (110) to form a solar cell string (100) according to a preset string forming mode;
wherein during forming the solar cell string (100), a plurality of solder strips (120), a plurality of adhesive dots (130), and a covering film (140) are arranged on a target side of the solar cell (110) in a preset sequence;
for the same target side, the covering film (140) is located on a side of the solder strip (120) away from the solar cell (110), and an orthographic projection of the covering film (140) on a reference plane and orthographic projections of the plurality of solder strips (120) on the reference plane have an overlapped projection; each solder strip (120) corresponds to at least one adhesive dot (130), and an orthographic projection of the adhesive dot (130) on the reference plane and an orthographic projection of the corresponding solder strip (120) on the reference plane have an overlapped projection; and the target side of the solar cell (110) is at least one side of the solar cell (110) along a first direction, the first direction is a thickness direction of the solar cell (110), and the reference plane is a plane perpendicular to the first direction.

2. The method for manufacturing the photovoltaic module (10) according to claim 1, wherein among all the adhesive dots (130) on the same target side of the same solar cell (110), a first target adhesive dot (130a) exists; and
at least a part of the first target adhesive dot (130a) is located between the corresponding solder strip (120) and the corresponding solar cell (110) along the first direction.

3. The method for manufacturing the photovoltaic module (10) according to claim 2, wherein for the same target side of the same solar cell (110), an orthographic projection of at least one first target adhesive dot (130a) on the reference plane and an orthographic projection of the corresponding covering film (140) on the reference plane have an overlapped projection; and/or
for the same target side of the same solar cell (110), an orthographic projection of at least one first target adhesive dot (130a) on the reference plane is not overlapped with an orthographic projection of the corresponding covering film (140) on the reference plane.

4. The method for manufacturing the photovoltaic module (10) according to any one of claims 1 to 3, wherein among all the adhesive dots (130) on the same target sides of all the solar cells (110), a second target adhesive dot (130b) exists; and
at least a part of the second target adhesive dot (130b) is located between the corresponding solder strip (120) and the corresponding covering film (140) along the first direction.

5. The method for manufacturing the photovoltaic module (10) according to any one of claims 1 to 4, wherein among all the adhesive dots (130) on the same target sides of all the solar cells (110), a third target adhesive dot (130c) exists; and at least a part of the third target adhesive dot (130c) is located on a side of the corresponding covering film (140) away from the solar cell (110) along the first direction; and/or among all the adhesive dots (130) on the same target sides of all the solar cells (110), a fourth target adhesive dot (130d) exists; and at least a part of the fourth target adhesive dot (130d) is located on a side of the corresponding solder strip (120) away from the solar cell (110) along the first direction.

6. The method for manufacturing the photovoltaic module (10) according to any one of claims 1 to 5, wherein for the same target sides of all the solar cells (110), one covering film (140) is provided; and an orthographic projection of at least a part of the solder strip (120) on the reference plane and an orthographic projection of the corresponding covering film (140) on the reference plane have an overlapped projection; or
for the same target sides of all the solar cells (110), a plurality of covering films (140) are provided, each covering film (140) covers at least one solar cell (110), the covering films (140) are all not overlapped with each other, and an orthographic projection of at least a part of the solder strip (120) on the reference plane and an orthographic projection of the corresponding covering film (140) on the reference plane have an overlapped projection; or
for the same target sides of all the solar cells (110), a plurality of covering films (140) are provided, all the covering films (140) and all the solar cells (110) are arranged in one-to-one correspondence, and an orthographic projection of at least a part of the solder strip (120) on the reference plane and an orthographic projection of the corresponding covering film (140) on the reference plane have an overlapped projection.

7. The method for manufacturing the photovoltaic module (10) according to any one of claims 1 to 6, wherein each solder strip (120) corresponds to a plurality of adhesive dots (130);
orthographic projections of the plurality of adhesive dots (130) on the reference plane respectively have an overlapped projection with an orthographic projection of the corresponding solder strip (120) on the reference plane.

8. The method for manufacturing the photovoltaic module (10) according to claim 7, wherein the solder strip (120) has a first end portion (e1) and a second end portion (e2) oppositely arranged along a lengthwise direction of the solder strip (120); and
for the plurality of adhesive dots (130), an orthographic projection of one of the plurality of adhesive dots (130) on the reference plane and an orthographic projection of the first end portion (e1) of the corresponding solder strip (120) on the reference plane have an overlapped projection; and an orthographic projection of another adhesive dot (130) on the reference plane and an orthographic projection of the second end portion (e2) of the corresponding solder strip (120) on the reference plane have an overlapped projection.

9. The method for manufacturing the photovoltaic module (10) according to any one of claims 1 to 8, wherein the covering film (140) is configured into a single-layer structure, and a pre-cross-linking degree of the covering film (140) is 20% to 50%; or
the covering film (140) is configured into a multi-layer structure, the covering film (140) comprises a plurality of stacked sub-covering films, and a pre-cross-linking degree of a sub-covering film in the plurality of sub-covering films closest to the solar cell (110) is 20% to 50%.

10. The method for manufacturing the photovoltaic module (10) according to any one of claims 1 to 9, wherein for the same target side of the same solar cell (110), an orthographic projection of each solder strip (120) on the reference plane and an orthographic projection of the corresponding covering film (140) on the reference plane have an overlapped projection.

11. The method for manufacturing the photovoltaic module (10) according to any one of claims 1 to 10, wherein a lowest torque value ML of the covering film satisfies: 0.1≤ML≤0.8; and/or a temperature of the covering film during application is 100°C to 135°C; and/or a thickness of the covering film is 50 µm to 500 µm.

12. The method for manufacturing the photovoltaic module (10) according to any one of claims 1 to 11, wherein the method further comprises curing the adhesive dots (130) during forming the solar cell string (100), and a cross-linking degree of the adhesive dots (130) after curing is larger than 90%.

13. The method for manufacturing the photovoltaic module (10) according to any one of claims 1 to 12, wherein Tg of the adhesive dot (130) is larger than or equal to 59.40°C; where Tg is a temperature at which the adhesive dot (130) is transformed from a glassy state to a high-condensed state.

14. The method for manufacturing the photovoltaic module (10) according to any one of claims 1 to 13, wherein the solder strip (120) comprises at least one of a round wire solder strip, a triangular solder strip, a flat solder strip, or a special-shaped solder strip.

15. A photovoltaic module (10) prepared by the method for manufacturing the photovoltaic module according to any one of claims 1 to 14.

## Amended claims

### Amended claims in accordance with Rule 137(2) EPC.

1. A method for manufacturing a photovoltaic module (10), comprising:
providing solar cells (110); and
connecting a plurality of solar cells (110) to form a solar cell string (100) according to a preset string forming mode; wherein during forming the solar cell string (100), a plurality of solder strips (120), a plurality of adhesive dots (130), and a covering film (140) are arranged on a target side of the solar cell (110) in a preset sequence;
for the same target side, the covering film (140) is located on a side of the solder strip (120) away from the solar cell (110), and an orthographic projection of the covering film (140) on a reference plane and orthographic projections of the plurality of solder strips (120) on the reference plane have an overlapped projection; each solder strip (120) corresponds to at least one adhesive dot (130), and an orthographic projection of the adhesive dot (130) on the reference plane and an orthographic projection of the corresponding solder strip (120) on the reference plane have an overlapped projection; and the target side of the solar cell (110) is at least one side of the solar cell (110) along a first direction, the first direction is a thickness direction of the solar cell (110), and the reference plane is a plane perpendicular to the first direction;
**characterized in that**: among all the adhesive dots (130) on the same target sides of all the solar cells (110), a third target adhesive dot (130c) exists; and at least a part of the third target adhesive dot (130c) is located on a side of the corresponding covering film (140) away from the solar cell (110) along the first direction.

2. The method for manufacturing the photovoltaic module (10) according to claim 1, wherein among all the adhesive dots (130) on the same target side of the same solar cell (110), a first target adhesive dot (130a) exists; and
at least a part of the first target adhesive dot (130a) is located between the corresponding solder strip (120) and the corresponding solar cell (110) along the first direction.

3. The method for manufacturing the photovoltaic module (10) according to claim 2, wherein for the same target side of the same solar cell (110), an orthographic projection of at least one first target adhesive dot (130a) on the reference plane and an orthographic projection of the corresponding covering film (140) on the reference plane have an overlapped projection; and/or
for the same target side of the same solar cell (110), an orthographic projection of at least one first target adhesive dot (130a) on the reference plane is not overlapped with an orthographic projection of the corresponding covering film (140) on the reference plane.

4. The method for manufacturing the photovoltaic module (10) according to any one of claims 1 to 3, wherein among all the adhesive dots (130) on the same target sides of all the solar cells (110), a second target adhesive dot (130b) exists; and
at least a part of the second target adhesive dot (130b) is located between the corresponding solder strip (120) and the corresponding covering film (140) along the first direction.

5. The method for manufacturing the photovoltaic module (10) according to any one of claims 1 to 4, wherein among all the adhesive dots (130) on the same target sides of all the solar cells (110), a fourth target adhesive dot (130d) exists; and at least a part of the fourth target adhesive dot (130d) is located on a side of the corresponding solder strip (120) away from the solar cell (110) along the first direction.

6. The method for manufacturing the photovoltaic module (10) according to any one of claims 1 to 5, wherein for the same target sides of all the solar cells (110), one covering film (140) is provided; and an orthographic projection of at least a part of the solder strip (120) on the reference plane and an orthographic projection of the corresponding covering film (140) on the reference plane have an overlapped projection; or
for the same target sides of all the solar cells (110), a plurality of covering films (140) are provided, each covering film (140) covers at least one solar cell (110), the covering films (140) are all not overlapped with each other, and an orthographic projection of at least a part of the solder strip (120) on the reference plane and an orthographic projection of the corresponding covering film (140) on the reference plane have an overlapped projection; or
for the same target sides of all the solar cells (110), a plurality of covering films (140) are provided, all the covering films (140) and all the solar cells (110) are arranged in one-to-one correspondence, and an orthographic projection of at least a part of the solder strip (120) on the reference plane and an orthographic projection of the corresponding covering film (140) on the reference plane have an overlapped projection.

7. The method for manufacturing the photovoltaic module (10) according to any one of claims 1 to 6, wherein each solder strip (120) corresponds to a plurality of adhesive dots (130);
orthographic projections of the plurality of adhesive dots (130) on the reference plane respectively have an overlapped projection with an orthographic projection of the corresponding solder strip (120) on the reference plane.

8. The method for manufacturing the photovoltaic module (10) according to claim 7, wherein the solder strip (120) has a first end portion (e1) and a second end portion (e2) oppositely arranged along a lengthwise direction of the solder strip (120); and
for the plurality of adhesive dots (130), an orthographic projection of one of the plurality of adhesive dots (130) on the reference plane and an orthographic projection of the first end portion (e1) of the corresponding solder strip (120) on the reference plane have an overlapped projection; and an orthographic projection of another adhesive dot (130) on the reference plane and an orthographic projection of the second end portion (e2) of the corresponding solder strip (120) on the reference plane have an overlapped projection.

9. The method for manufacturing the photovoltaic module (10) according to any one of claims 1 to 8, wherein the covering film (140) is configured into a single-layer structure, and a pre-cross-linking degree of the covering film (140) is 20% to 50%; or
the covering film (140) is configured into a multi-layer structure, the covering film (140) comprises a plurality of stacked sub-covering films, and a pre-cross-linking degree of a sub-covering film in the plurality of sub-covering films closest to the solar cell (110) is 20% to 50%.

10. The method for manufacturing the photovoltaic module (10) according to any one of claims 1 to 9, wherein for the same target side of the same solar cell (110), an orthographic projection of each solder strip (120) on the reference plane and an orthographic projection of the corresponding covering film (140) on the reference plane have an overlapped projection.

11. The method for manufacturing the photovoltaic module (10) according to any one of claims 1 to 10, wherein a temperature of the covering film during application is 100°C to 135°C; and/or
a thickness of the covering film is 50 µm to 500 µm.

12. The method for manufacturing the photovoltaic module (10) according to any one of claims 1 to 11, wherein the method further comprises curing the adhesive dots (130) during forming the solar cell string (100), and a cross-linking degree of the adhesive dots (130) after curing is larger than 90%.

13. The method for manufacturing the photovoltaic module (10) according to any one of claims 1 to 12, wherein Tg of the adhesive dot (130) is larger than or equal to 59.40°C; where Tg is a temperature at which the adhesive dot (130) is transformed from a glassy state to a high-condensed state.

14. The method for manufacturing the photovoltaic module (10) according to any one of claims 1 to 13, wherein the solder strip (120) comprises at least one of a round wire solder strip, a triangular solder strip, a flat solder strip, or a special-shaped solder strip.

15. A photovoltaic module (10) prepared by the method for manufacturing the photovoltaic module according to any one of claims 1 to 14, comprising:
a solar cell string (100) formed by connecting a plurality of solar cells (110) according to a preset string forming mode;
a plurality of solder strips (120), a plurality of adhesive dots (130), and a covering film (140) arranged on a target side of the solar cell (110) in a preset sequence;
an encapsulation layer (200) configured to cover a surface of the solar cell string (100); and
a cover plate (300) configured to cover a surface of the encapsulation layer (200) away from the solar cell string (100);
wherein for the same target side, the covering film (140) is located on a side of the solder strip (120) away from the solar cell (110), and an orthographic projection of the covering film (140) on a reference plane and orthographic projections of the plurality of solder strips (120) on the reference plane have an overlapped projection; each solder strip (120) corresponds to at least one adhesive dot (130), and an orthographic projection of the adhesive dot (130) on the reference plane and an orthographic projection of the corresponding solder strip (120) on the reference plane have an overlapped projection; and the target side of the solar cell (110) is at least one side of the solar cell (110) along a first direction, the first direction is a thickness direction of the solar cell (110), and the reference plane is a plane perpendicular to the first direction;
**characterized in that**:
wherein among all the adhesive dots (130) on the same target sides of all the solar cells (110), a third target adhesive dot (130c) exists; and at least a part of the third target adhesive dot (130c) is located on a side of the corresponding covering film (140) away from the solar cell (110) along the first direction.
